# EUROPEAN PATENT APPLICATION

(11) **EP 4 700 471 A1**
(43) Date of publication of application: **25.02.2026**
(21) Application number: 25195642.1
(22) Date of filing: 13.08.2025
(51) Int. Cl.: G03F 1/24, G03F 7/075, G03F 7/11

(54) **PHOTOMASK BLANK, METHOD FOR PROCESSING PHOTOMASK BLANK, AND METHOD FOR MANUFACTURING PHOTOMASK BLANK**

(30) Priority: 21.08.2024 JP 2024139925
(71) Applicant: Shin-Etsu Chemical Co., Ltd., Chiyoda-ku Tokyo 100-0005 (JP)
(72) Inventor: Kotake, Masaaki, Niigata (JP); Matsuzawa, Yuta, Niigata (JP); Watanabe, Satoshi, Niigata (JP); Suzuki, Hirotaka, Niigata (JP)
(74) Representative: Schicker, Silvia

(57) **Abstract**

The present invention is a photomask blank. The photomask blank includes: a substrate; a multilayer reflective film layer that is formed on the substrate and reflects an EUV light; an absorber layer that is formed on the multilayer reflective film layer and absorbs the EUV light; a silicon-containing hard mask film that is formed directly or indirectly on the absorber layer; and a photoresist film formed on the silicon-containing hard mask film; wherein the silicon-containing hard mask film is a cured material of a composition for forming a silicon-containing hard mask film, and the composition is to cure at a temperature of 50°C or more and 180°C or less. The present invention can provide a photomask blank containing a silicon-containing hard mask film that can function as a hard mask when an absorber layer is being processed by dry etching, and can also contribute to improving the resolution of a resist pattern.

## Description

### TECHNICAL FIELD

The present invention relates to a photomask blank that is a material for producing a photomask and has a hard mask film for when etching a thin film formed on a substrate, and a method for processing the photomask blank using the photomask blank, and a method for manufacturing it.

### BACKGROUND ART

Along with the miniaturization of semiconductor devices, an exposure method is currently performed in which a photomask and an optical projection exposure apparatus using an ArF excimer laser are used to transfer a pattern onto a wafer. However, in these exposure methods using the optical projection exposure apparatus, the resolution limit will eventually be reached. Therefore, new patterning methods such as direct drawing using an electron beam lithography system, imprint lithography, and EUV lithography have been proposed.

Among these new lithography techniques, EUV exposure regarded as the limit of short wavelength conversion is a technique wherein EUV light having a wavelength of about 13.5 nm, which is shorter than that of an excimer laser, is used to perform exposure, while usually reducing to about 1/4. Therefore, it is attracting attention as a next-generation lithography technique for semiconductor devices. In EUV exposure, a refractive optical system cannot be used due to the short wavelength; therefore, a reflective optical system is used, and a reflective mask has been proposed (Patent Document 1). As the reflective film having multilayer structure adopted for the reflective mask (multilayer reflective film layer), a multilayer film is normally used, wherein films of material with relatively high refractive index and films of material with relatively low refractive index are alternately stacked on the order of a few nanometers. For example, a multilayer film made by alternately stacking thin films of Si and thin films of Mo is known to have high reflectivity to EUV light of 13 to 14 nm.

In forming a photomask pattern, for example, a photomask blank is produced by forming a photoresist film on a composite substrate having a substrate, a multilayer reflective film layer on the substrate, a capping layer on the multilayer reflective film layer, the capping layer preventing oxidation of the multilayer reflective film layer and acting as a protective layer during mask washing, a buffer layer on the capping layer, the buffer layer preventing damage due to etching during mask pattern formation, an absorber layer on the buffer layer that absorbs EUV light, and a hard mask layer on the absorber layer, the hard mask layer being resistant to etching of the absorber layer. The photoresist film of this photomask blank is subjected to electron beam pattern exposure and then developed to obtain a resist pattern, and then the absorber layer is etched using the obtained resist pattern as a mask to process it to become an absorber layer pattern. However, in the case where the absorber layer pattern is to be miniaturized, if the photoresist film is processed while keeping its thickness the same as before the miniaturization, the ratio of film thickness to the pattern, that is, the aspect ratio, might become larger, and the photoresist pattern shape might be degraded and the pattern transfer will become difficult, and in some cases, the resist pattern might collapse or be peeled off. Therefore, the resist film thickness must be made thinner along with the miniaturization.

On the other hand, for the absorber layer, which is etched while using a resist pattern as a mask, materials containing Ta as the main component, such as Ta, TaB, TaBN, TaO, and TaN, and materials containing Cr or having Cr as the main component with at least one component selected from N, O, and C, have been used. In the etching of materials containing Ta as the main component, patterning can be performed using chlorine-based dry etching, and in the etching of materials containing Cr as the main component, patterning can be performed using fluorine-based dry etching. However, in the method of etching the absorber layer in which a resist film having been thinned due to the reasons mentioned above is used, it is no longer possible to ensure sufficient processing accuracy when forming mask patterns used for EUV exposure. Therefore, it is necessary to form a hard mask layer under the photoresist film.

Although it is not a method for processing a reflective photomask blank, for example, Patent Document 2 discloses that, in order to perform dry etching of a light shielding film made of a silicon-based material while using a thin resist film, a chromium-based material film having enough small thickness to act as a hard mask can be used as the hard mask film, thereby enabling the accuracy of the obtained mask pattern to be made high. Similarly, Patent Document 3 discloses that a silicon-based material film can be used as a hard mask for a chrome-based light-shielding film.

As a method for forming a hard mask, as described above, by alternately forming films of a chromium-based material, which are generally to be processed under chlorine-based dry etching conditions, and a material containing a transition metal and silicon, which are generally to be processed under fluorine-based dry etching conditions, using an SOG film as a hard mask film when processing a chromium-based material film has been proposed (Patent Document 4).

When using an SOG film as a hard mask film, it is necessary to perform a baking process at high temperature after applying the SOG film to cure it in order to prevent it from mixing with the photoresist film. For example, in the Examples in Patent Document 4, baking is performed at 190°C. On the other hand, there is no mention of whether an SOG film can be used as a hard mask in the method for processing a reflective photomask blank composed of multilayer reflective film layers, and therefore its practicality as an EUV photomask blank is still unclear. One of the reasons for this is speculated to be that, with a reflective photomask blank, when the SOG film is cured, the multilayer reflective film layer stacked below the SOG film is also subjected to a high temperature, and the periodic structure of the multilayer reflective film layer is disturbed, resulting in reducing the EUV-light reflectivity and generating phase defects.

In the Examples in Patent Document 5, a phase shifting film is formed on a quartz substrate, a light shielding layer is formed on the film to provide a mask blank, a silicon-containing composition is spin-coated thereon, and baking at 250°C is performed to form a silicon containing film.

### CITATION LIST

### PATENT LITERATURE

Patent Document 1: JPS63-201656A
Patent Document 2: JP2007-241060A
Patent Document 3: JP2006-146152A
Patent Document 4: JP2008-26500A
Patent Document 5: JP2010-230986A

### SUMMARY OF INVENTION

### TECHNICAL PROBLEM

As mentioned above, in order to further improve the accuracy of reflective photomask techniques, there is a demand for the resist pattern to be transferred to the absorber layer with higher accuracy. The use of SOG films as a hard mask film is useful from the viewpoint of compensating for the lack of dry etching resistance of thin film photoresists and from the viewpoint of improving the pattern resolution of photoresists; however, the prevention of mixing with photoresists and the prevention of interlayer mixing of multilayer reflective film layer are still required to be improved.

The present invention has been made in view of the above circumstances. The purpose of the present invention is to provide a photomask blank including a silicon-containing hard mask film that can function as a hard mask when an absorber layer is processed by dry etching, and can also contribute to improving the resolution of a resist pattern; a method for processing a photomask blank using the same; and a method for manufacturing this photomask blank.

### SOLUTION TO PROBLEM

In order to solve the above problems, the present invention provides a photomask blank,
wherein the photomask blank comprises
a substrate;
a multilayer reflective film layer that is formed on the substrate and reflects an EUV light;
an absorber layer that is formed on the multilayer reflective film layer and absorbs the EUV light;
a silicon-containing hard mask film that is formed directly or indirectly on the absorber layer; and
a photoresist film formed on the silicon-containing hard mask film;
wherein the silicon-containing hard mask film is a cured material of a composition for forming a silicon-containing hard mask film, the composition for forming a silicon-containing hard mask film is to cure at a temperature of 50°C or more and 180°C or less.

Since such a photomask blank contains a silicon-containing hard mask film that is useful as a hard mask film, a fine resist pattern can be transferred to the absorber layer with high accuracy. In addition, since the silicon-containing hard mask film can be formed within the above temperature range, the transfer accuracy of the resist pattern can be improved without inducing interlayer mixing of the multilayer reflective film layer. That is, by using the photomask blank of the present invention, it is possible to provide a photomask having an absorber layer, wherein a fine pattern is formed with high accuracy without degrading the EUV-light reflectivity. In other words, the photomask blank of the present invention is a photomask blank that contains a silicon-containing hard mask film that can function as a hard mask when the absorber layer is processed, and can also contribute to improving the resolution of a resist pattern.

In addition, it is preferable that the composition for forming a silicon-containing hard mask film contains a silicon-containing compound having one or more of a repeating unit represented by the following general formula (Sx-1), a repeating unit represented by the following general formula (Sx-2), and a partial structure represented by the following general formula (Sx-3), 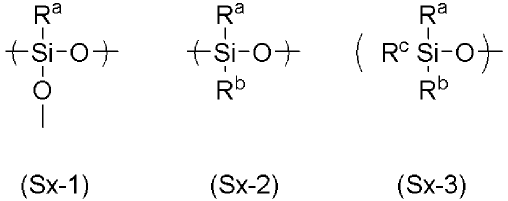 wherein R^{a}, R^{b}, and R^{c} are monovalent organic groups having 1 to 30 carbon atoms, and may be the same as or different from each other.

Such a composition for forming a silicon-containing hard mask film has excellent thermosetting properties, therefore a cured film can be formed by baking at a temperature of 50°C or more and 180°C or less. In addition, it is possible to form a silicon-containing hard mask film with excellent dry-etching resistance. Therefore, such a photomask blank containing a cured product of such a composition for forming silicon-containing hard mask can provide a photomask containing an absorber layer having a fine pattern formed with higher accuracy.

In this case, at least one of R^{a} to R^{c} in the formulas (Sx-1) to (Sx-3) is preferably an organic group having one or more of a carbon-oxygen single bond and a carbon-oxygen double bond.

A composition for forming a silicon-containing hard mask film having such an organic group has excellent thermosetting properties, so a cured film can be formed by baking at a temperature of 50°C or more and 180°C or less.

The composition for forming a silicon-containing hard mask film preferably further contains a crosslinking catalyst.

Such a composition for forming a silicon-containing hard mask film has further excellent thermosetting properties, and therefore a cured film can be certainly formed by baking at a temperature of 50°C or more and 180°C or less.

The crosslinking catalyst is preferably a sulfonium salt, an iodonium salt, a phosphonium salt, an ammonium salt, an alkali metal salt, or a polysiloxane having any one of a sulfonium salt, an iodonium salt, a phosphonium salt, and an ammonium salt as part of its structure.

Such a composition for forming a silicon-containing hard mask film has particularly excellent thermosetting properties, and therefore a cured film can be more reliably formed by baking at a temperature of 50°C or more and 180°C or less.

The present invention also provides a method for processing a photomask blank, including:
(i-1) a step of forming a photoresist pattern on the photoresist film wherein the photomask blank according to the present invention is irradiated with an electron beam, and then a development is performed with a developer;
(i-2) a step of forming a silicon-containing film pattern on the silicon-containing hard mask film by etching the silicon-containing hard mask while using the photoresist pattern as a mask; and
(i-3) a step of directly or indirectly processing the absorber layer by performing etching while using the silicon-containing film pattern as a mask.

Such a method for processing of photomask blank uses the silicon-containing hard mask film as a hard mask having better dry-etching resistance to chlorine-based gases than the photoresist film, and therefore the resist pattern can be transferred to the absorber layer of the photomask blank with high accuracy. In addition, since the silicon-containing hard mask film can be formed within the temperature range of 50°C to 180°C, the transfer accuracy of the resist pattern can be improved without inducing interlayer mixing of the multilayer reflective film layers. That is, by using the method for processing the photomask blank of the present invention, it is possible to provide a photomask having an absorber layer in which a fine pattern has been formed with high accuracy without degrading the EUV-light reflectivity.

The present invention also provides a method for manufacturing a photomask blank, comprising:
a step of providing a substrate;
a step of forming a multilayer reflective film layer that reflects an EUV light on the substrate;
a step of forming an absorber layer that absorbs the EUV light on the multilayer reflective film layer;
a step of applying a composition for forming a silicon-containing hard mask film directly or indirectly onto the absorber layer, the composition for forming a silicon-containing hard mask film being to cure at a temperature of 50°C or higher and 180°C or lower, to obtain a coating film, and curing the coating film at a temperature of 50°C or higher and 180°C or lower so as to form a silicone-containing hard mask film; and
a step of forming a photoresist film on the silicon-containing hard mask film.

Such a method for manufacturing a photomask blank can form a silicon-containing hard mask film that is useful as a hard mask, and therefore it is possible to manufacture a photomask blank that can transfer a fine resist pattern to absorber layers with high accuracy. In addition, by forming the silicon-containing hard mask film within the above temperature range, it is possible to improve the transfer accuracy of the resist pattern without inducing interlayer mixing of the multilayer reflective film layer. That is, the method for manufacturing the photomask blank of the present invention can provide a photomask that includes an absorber layer in which a fine pattern has been formed with high accuracy without degrading the EUV-light reflectivity.

### ADVANTAGEOUS EFFECTS OF INVENTION

As described above, by using the photomask blank of the present invention, it is possible to provide a photomask having an absorber layer wherein a fine pattern has been formed with high accuracy without degrading the EUV-light reflectivity. That is, the photomask blank of the present invention is a photomask blank containing a silicon-containing hard mask film that can function as a hard mask when the absorber layer is processed by dry etching, and can also contribute to improving the resolution of a resist pattern.

In addition, the method for processing the photomask blank of the present invention can provide a photomask having an absorber layer wherein a fine pattern has been formed with high accuracy without degrading the EUV-light reflectivity.

In addition, the method for manufacturing the photomask blank of the present invention can manufacture a photomask blank that can form fine patterns in the absorber layer with high accuracy without degrading the EUV-light reflectivity.

### BRIEF DESCRIPTION OF DRAWINGS

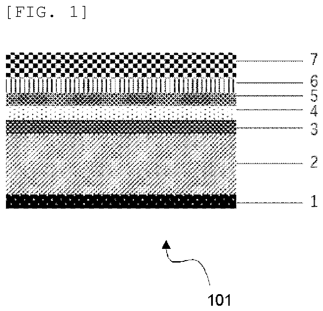

FIG. 1 is a schematic cross-sectional view illustrating an example of the photomask blank according to the present invention.

### DESCRIPTION OF EMBODIMENTS

As mentioned above, in order to further improve the accuracy of reflective photomask techniques, there is a demand for the resist pattern to be transferred to the absorber layer with higher accuracy. The use of SOG films as hard mask films is useful from the viewpoint of compensating for the insufficient dry-etching resistance of thin film photoresist (Patent Document 4), and is also expected to improve the pattern resolution of photoresist. However, it is not clear whether an SOG film can be used as a hard mask in the method for processing a reflective photomask with a multilayer reflective film. Furthermore, in a reflective photomask, when the SOG film is cured, the multilayer reflective film layer stacked below the SOG film is also subjected to a high temperature, and the periodic structure of the multilayer reflective film is disturbed, resulting in reducing the EUV-light reflectivity and generating phase defects. This is considered to be a problem.

The present inventors explored, thoroughly review and considered a photomask blank wherein a resist pattern was transferred to an absorber layer with high accuracy, and a method for processing the photomask blank and method for manufacturing the photomask blank. As a result, the present inventors found that, by using a cured product formed from a composition for forming a silicon-containing hard mask film, the composition being to cure at a temperature of 50°C or more and 180°C or less, it is possible to improve the transfer accuracy of a resist pattern to an absorber layer without inducing interlayer mixing of a multilayer reflective film layer. Based on this finding, the present invention was completed.

That is, the present invention is a photomask comprising:
a substrate;
a multilayer reflective film layer that is formed on the substrate and reflects an EUV light;
an absorber layer that is formed on the multilayer reflective film layer and absorbs the EUV light;
a silicon-containing hard mask film that is formed directly or indirectly on the absorber layer; and
a photoresist film formed on the silicon-containing hard mask film;
wherein the silicon-containing hard mask film is a cured material of a composition for forming a silicon-containing hard mask film, the composition for forming a silicon-containing hard mask film is to cure at a temperature of 50°C or more and 180°C or less.

Since the photomask blank, the method for processing the photomask blank, and the method for manufacturing the photomask blank of the present invention use, as a hard mask, a cured product formed with a composition for forming a silicon-containing hard mask film that can be cured at a temperature of 50°C or more and 180°C or less, the transfer accuracy of a resist pattern to an absorber layer can be improved without inducing interlayer mixing of a multilayer reflective film layer. That is, the present invention can provide a photomask blank capable of achieving a photomask comprising an absorber layer, wherein a fine pattern has been formed with high accuracy without degrading the EUV-light reflectivity, so it is extremely useful for fine patterning for semiconductor device manufacturing.

Hereinafter, the present invention will be described in detail. However, the present invention is not limited thereto.

### <Photomask blank>

First, the structures of the reflective photomask blank and the reflective photomask blank of the present invention will be described below with reference to the drawings. In the descriptions of the drawings, in some cases, the same components are denoted by the same reference symbols, and the descriptions thereof are sometimes omitted. In addition, in some cases, the drawings are expanded and shown for convenience, and the dimensional ratios of each component are not necessarily the same as in reality.

In the present description, curing of the composition for forming a silicon-containing hard mask film means that when a photoresist material is applied onto the silicon-containing hard mask film, the amount of film loss of the silicon-containing hard mask film is very small, and no mixing with the photoresist film occurs. The amount of film loss of the silicon-containing hard mask film in this case is preferably less than 5%, more preferably less than 3%, further preferably less than 1%, and particularly preferably less than 0.5% of the film thickness compared to the film thickness before the photoresist material is applied.

### [Overall structure of photomask blank]

The photomask blank (reflective mask blank) of the present invention generally comprises a substrate, a multilayer reflective film layer that reflects EUV light (exposure light) formed on the substrate (for example, on one major surface (the front surface) of the substrate), an absorber layer (light absorbing film) formed on the multilayer reflective film layer, a silicon-containing hard mask film formed directly or indirectly on the absorber layer, and a photoresist film formed on the silicon-containing hard mask film. The photomask blank may further have an etching mask film that functions as an etching mask for processing of the absorber film. In addition, a back surface conductive film may be provided on the other major surface (the back surface) of the substrate. Furthermore, the photomask blank may also comprise a protective film.

FIG. 1 is a schematic cross-sectional view illustrating an example of the photomask blank (reflective photomask blank) of the present invention. This reflective photomask blank 101 has, a substrate 1; a multilayer reflective film layer 2 that reflects the exposure light, which is EUV light, and is formed on and in contact with the substrate 1; a protective film 3 (optional component in the present invention) that is for protecting the multilayer reflective film layer 2 and, is formed on and in contact with the multilayer reflective film layer 2; an absorber layer 4 (light absorbing film) that absorbs the exposure light and is formed on and in contact with the protective film 3; a first layer 5 (optional constituent in the present invention) of a hard mask film that is formed on and in contact with the absorber layer 4 and functions as a hard mask when the absorber layer 4 is patterned by dry etching; a silicon-containing hard mask film 6 that functions as a second layer of the hard mask film when the first layer 5 of the hard mask film is patterned by dry etching; and a photoresist film 7 that is formed on and in contact with the silicon-containing hard mask film 6.

Hereinafter, each of the components (essential parts and optional parts) of the photomask blank of the present invention will be described in detail below.

### [Substrate]

The substrate preferably has low thermal expansion characteristics; for example, it is preferably formed from materials that have a thermal expansion coefficient within the range of ±2×10⁻⁸/°C. Such materials include titania-doped quartz glass (SiO₂-TiO₂ based glass) . Additionally, the surface roughness of a major surface of the substrate is preferably 0.5 nm or less in terms of RMS value.

### [Back surface conductive film]

A conductive film (back surface conductive film) used for conducting electrostatic chucking of a reflective photomask to an exposure apparatus (for example, an EUV scanner) may be provided on the other major surface (back surface) of the substrate, which is the surface on the opposite side to one major surface.

The sheet resistance of the back surface conductive film is preferably 100 Ω/□ or less, and there are no particular restrictions on the material. Examples of materials for the back surface conductive film include materials containing tantalum (Ta) or chromium (Cr). It may also contain oxygen (O), nitrogen (N), etc. The thickness of the back surface conductive film is not particularly limited as long as it functions for electrostatic chucking, but is usually around 20 to 300 nm.

### [Multilayer reflective film layer]

The multilayer reflective film layer is the film that reflects the EUV light that is the exposure light in a reflective mask. The multilayer reflective film has a periodic stacking structure wherein, for example, high-refractive-index layers, which have a relatively high refractive index for the exposure light, and low-refractive-index layers, which have a relatively low refractive index for the exposure light, are alternately stacked.

The high-refractive-index layers are preferably formed from materials containing silicon (Si), and the low-refractive-index layers are preferably formed from materials containing molybdenum (Mo). The thickness of the multilayer reflective film is preferably 270 nm or more and preferably 400 nm or less.

### [Protective film]

The optional protective film is also called a capping film. The protective film is a film for protecting the multilayer reflective film layer. The protective film is preferably formed from a material containing ruthenium (Ru), and may further contain titanium (Ti), zirconium (Zr), niobium (Nb), etc. It may also contain oxygen (O), nitrogen (N), carbon (C), etc. The thickness of the protective film is not particularly limited, but is preferably 2 nm or more and preferably 5 nm or less.

### [Absorber layer]

The absorber layer (light absorbing film) is made of a material that absorbs EUV light and can be pattern-processed. The material of the absorber layer is not particularly limited, but is, for example, preferably a film containing tantalum (Ta), and also may contain oxygen (O), nitrogen (N), boron (B), etc. The thickness of the absorber layer is not particularly limited, but is preferably 50 nm or more and 80 nm or less.

### [First layer of hard mask film]

The first layer of the hard mask film, which is an optional constituent for the present invention, is a layer that can function as an etching mask (hard mask) in etching of the absorber layer.

The first layer of the hard mask film is preferably made of a material that is resistant to the fluorine-based dry etching for the absorber layer and can be removed by chlorine-based dry etching. The first layer of the hard mask film is preferably formed by a material containing chromium (Cr). In addition to chromium, the material may contain one or more elements selected from oxygen (O), nitrogen (N), and carbon (C), and more preferably may contain a material consisting of chromium and one or more elements selected from oxygen, nitrogen, and carbon. It preferably contains nitrogen, and in particular, chromium nitride (CrN), consisting of chromium and nitrogen, is suitable. Also, together with nitrogen, it preferably contains oxygen, and in particular, chromium oxide nitride (CrNO), consisting of chromium, nitrogen, and oxygen, is suitable.

Furthermore, it may contain carbon together with nitrogen and oxygen, and if it contains carbon, chromium nitride oxide carbide (CrNOC), composed of chromium, nitrogen, oxygen and carbon, is suitable. The thickness of the etching mask film is not particularly limited, but it is preferably 5 nm or more and preferably 20 nm or less.

### [Silicon-containing hard mask film (second layer of hard mask film)]

The silicon-containing hard mask film in the present invention (the second layer of the hard mask film) is a layer that can function, for example, as an etching mask (hard mask) in etching of the first layer of the hard mask film. When used as an etching mask in etching of the first layer of a hard mask film, the silicon-containing hard mask film (the second layer of the hard mask film) is preferably made of a material that is resistant to the chlorine-based dry etching for the first layer of the hard mask film and can be removed by fluorine-based dry etching. The silicon-containing hard mask film (the second layer of the hard mask film) is a cured product of a composition that contains silicon (Si); in other words, it is formed by a material that contains silicon (Si). The material containing silicon (Si) may contain, in addition to silicon, one or more elements selected from oxygen (O), nitrogen (N), and carbon (C), and is preferably a material consisting of silicon and one or more elements selected from oxygen, nitrogen, and carbon.

In the present invention, the silicon-containing hard mask film (the second layer of the hard mask film) is a cured product of a composition for forming a silicon-containing hard mask, the composition being to cure at a temperatures 50°C or more and 180°C or less. In particular, it is preferably a cured product (silicon oxide-based material film) obtained by applying the composition for forming a silicon-containing hard mask film (A) containing a silicon-containing compound having at least one of a repeating unit represented by the following general formula (Sx-1), a repeating unit represented by the following general formula (Sx-2), and a partial structure represented by the following general formula (Sx-3), and baking the composition at a temperature of 50°C or more and 150°C or less. 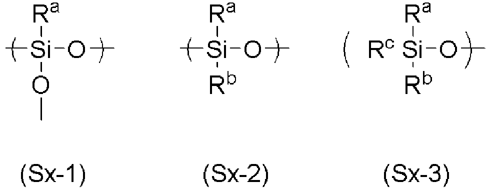 wherein R^{a}, R^{b}, and R^{c} are monovalent organic groups having 1 to 30 carbon atoms, and may be the same as or different from each other.

If the silicon-containing hard mask film is a cured product of a composition which is to cure at a temperature higher than 180°C, the reflectivity of the multilayer reflective film layer is reduced. On the other hand, if the silicon-containing hard mask film is a cured product of a composition which is to cure at a temperature below 50°C, then even if the composition is stored in the usage environment of the product (for example, in a clean room at 23°C), a part of the composition will hardens, causing defects.

The composition for forming a silicon-containing hard mask film (A) preferably contains a polysiloxane (Sx) and a solvent, and may further contain additives such as a crosslinking catalyst and a crosslinking agent.

Each component that may be contained in the composition for forming a silicon-containing hard mask film (A) will be described in more detail below.

### (Polysiloxane (Sx))

The polysiloxane (Sx) preferably contains one or more of a repeating unit represented by the following general formula (Sx-1), a repeating unit represented by the following general formula (Sx-2), and a partial structure represented by the following general formula (Sx-3). 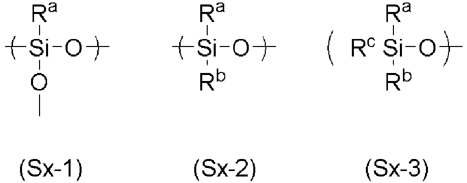 wherein R^{a}, R^{b}, and R^{c} are monovalent organic groups having 1 to 30 carbon atoms, and may be the same as or different from each other.

The polysiloxane (Sx) may be a thermally crosslinkable polysiloxane (Sx).

The thermally crosslinkable polysiloxane (Sx) can be produced by hydrolytic condensation of the following hydrolyzable monomer (Sm),

Specific examples of the hydrolyzable monomer (Sm) include tetramethoxysilane, tetraethoxysilane, tetrapropoxysilane, tetraisopropoxysilane, trimethoxysilane, triethoxysilane, tripropoxysilane, triisopropoxysilane, methyltrimethoxysilane, methyltriethoxysilane, methyltripropoxysilane, methyltriisopropoxysilane, ethyltrimethoxysilane, ethyltriethoxysilane, ethyltripropoxysilane, ethyltriisopropoxysilane, vinyltrimethoxysilane, vinyltriethoxysilane, vinyltripropoxysilane, vinyltriisopropoxysilane, propyltrimethoxysilane, propyltriethoxysilane, propyltripropoxysilane, propyltriisopropoxysilane, isopropyltrimethoxysilane, isopropyltriethoxysilane, isopropyltripropoxysilane, isopropyltriisopropoxysilane, butyltrimethoxysilane, butyltriethoxysilane, butyltripropoxysilane, butyltriisopropoxysilane, sec-butyltrimethoxysilane, sec-butyltriethoxysilane, sec-butyltripropoxysilane, sec-butyltriisopropoxysilane, t-butyltrimethoxysilane, t-butyltriethoxysilane, t-butyltripropoxysilane, t-butyltriisopropoxysilane, cyclopropyltrimethoxysilane, cyclopropyltriethoxysilane, cyclopropyltripropoxysilane, cyclopropyltriisopropoxysilane, cyclobutyltrimethoxysilane, cyclobutyltriethoxysilane, cyclobutyltripropoxysilane, cyclobutyltriisopropoxysilane, cyclopentyltrimethoxysilane, cyclopentyltriethoxysilane, cyclopentyltripropoxysilane, cyclopentyltriisopropoxysilane, cyclohexyltrimethoxysilane, cyclohexyltriethoxysilane, cyclohexyltripropoxysilane, cyclohexyltriisopropoxysilane, cyclohexenyltrimethoxysilane, cyclohexenyltriethoxysilane, cyclohexenyltripropoxysilane, cyclohexenyltriisopropoxysilane, cyclohexenylethyltrimethoxysilane, cyclohexenylethyltriethoxysilane, cyclohexenylethyltripropoxysilane, cyclohexenylethyltriisopropoxysilane, cyclooctyltrimethoxysilane, cyclooctyltriethoxysilane, cyclooctyltripropoxysilane, cyclooctyltriisopropoxysilane, cyclopentadienylpropyltrimethoxysilane, cyclopentadienylpropyltriethoxysilane, cyclopentadienylpropyltripropoxysilane, cyclopentadienylpropyltriisopropoxysilane, bicycloheptenyltrimethoxysilane, bicycloheptenyltriethoxysilane, bicycloheptenyltripropoxysilane, bicycloheptenyltriisopropoxysilane, bicycloheptyltrimethoxysilane, bicycloheptyltriethoxysilane, bicycloheptyltripropoxysilane, bicycloheptyltriisopropoxysilane, adamantyltrimethoxysilane, adamantyltriethoxysilane, adamantyltripropoxysilane, adamantyltriisopropoxysilane, phenyltrimethoxysilane, phenyltriethoxysilane, phenyltripropoxysilane, phenyltriisopropoxysilane, benzyltrimethoxysilane, benzyltriethoxysilane, benzyltripropoxysilane, benzyltriisopropoxysilane, anisyltrimethoxysilane, anisyltriethoxysilane, anisyltripropoxysilane, anisyltriisopropoxysilane, tolyltrimethoxysilane, tolyltriethoxysilane, tolyltripropoxysilane, tolyltriisopropoxysilane, phenethyltrimethoxysilane, phenethyltriethoxysilane, phenethyltripropoxysilane, phenethyltriisopropoxysilane, naphthyltrimethoxysilane, naphthyltriethoxysilane, naphthyltripropoxysilane, naphthyltriisopropoxysilane, dimethyldimethoxysilane, dimethyldiethoxysilane, methylethyldimethoxysilane, methylethyldiethoxysilane, dimethyldipropoxysilane, dimethyldiisopropoxysilane, diethyldimethoxysilane, diethyldiethoxysilane, diethyldipropoxysilane, diethyldiisopropoxysilane, dipropyldimethoxysilane, dipropyldiethoxysilane, dipropyldipropoxysilane, dipropyldiisopropoxysilane, diisopropyldimethoxysilane, diisopropyldiethoxysilane, diisopropyldipropoxysilane, diisopropyldiisopropoxysilane, dibutyldimethoxysilane, dibutyldiethoxysilane, dibutyldipropoxysilane, dibutyldiisopropoxysilane, di-sec-butyldimethoxysilane, di-sec-butyldiethoxysilane, di-sec-butyldipropoxysilane, di-sec-butyldiisopropoxysilane, di-t-butyldimethoxysilane, di-t-butyldiethoxysilane, di-t-butyldipropoxysilane, di-t-butyldiisopropoxysilane, dicyclopropyldimethoxysilane, dicyclopropyldiethoxysilane, dicyclopropyldipropoxysilane, dicyclopropyldiisopropoxysilane, dicyclobutyldimethoxysilane, dicyclobutyldiethoxysilane, dicyclobutyldipropoxysilane, dicyclobutyldiisopropoxysilane, dicyclopentyldimethoxysilane, dicyclopentyldiethoxysilane, dicyclopentyldipropoxysilane, dicyclopentyldiisopropoxysilane, dicyclohexyldimethoxysilane, dicyclohexyldiethoxysilane, dicyclohexyldipropoxysilane, dicyclohexyldiisopropoxysilane, dicyclohexenyldimethoxysilane, dicyclohexenyldiethoxysilane, dicyclohexenyldipropoxysilane, dicyclohexenyldiisopropoxysilane, dicyclohexenylethyldimethoxysilane, dicyclohexenylethyldiethoxysilane, dicyclohexenylethyldipropoxysilane, dicyclohexenylethyldiisopropoxysilane, dicyclooctyldimethoxysilane, dicyclooctyldiethoxysilane, dicyclooctyldi propoxysilane, dicyclooctyldiisopropoxysilane, dicyclopentadienylpropyldimethoxysilane, dicyclopentadienylpropyldiethoxysilane, dicyclopentadienylpropyldipropoxysilane, dicyclopentadienylpropyldiisopropoxysilane, bis(bicycloheptenyl)dimethoxysilane, bis(bicycloheptenyl)diethoxysilane, bis(bicycloheptenyl)dipropoxysilane, bis(bicycloheptenyl)diisopropoxysilane, bis(bicycloheptyl)dimethoxysilane, bis(bicycloheptyl)diethoxysilane, bis(bicycloheptyl)dipropoxysilane, bis(bicycloheptyl)diisopropoxysilane, diadamantyldimethoxysilane, diadamantyldiethoxysilane, diadamantyldipropoxysilane, diadamantyldiisopropoxysilane, diphenyldimethoxysilane, diphenyldiethoxysilane, methylphenyldimethoxysilane, methylphenyldiethoxysilane, diphenyldipropoxysilane, diphenyldiisopropoxysilane, trimethylmethoxysilane, trimethylethoxysilane, dimethylethylmethoxysilane, dimethylethylethoxysilane, dimethylphenylmethoxysilane, dimethylphenylethoxysilane, dimethylbenzylmethoxysilane, dimethylbenzylethoxysilane, dimethylphenethylmethoxysilane, and dimethylphenethylethoxysilane.

Preferable examples of the above hydrolizable monomer include tetramethoxysilane, tetraethoxysilane, methyltrimethoxysilane, methyltriethoxysilane, ethyltrimethoxysilane, ethyltriethoxysilane, vinyltrimethoxysilane, vinyltriethoxysilane, propyltrimethoxysilane, propyltriethoxysilane, isopropyltrimethoxysilane, isopropyltriethoxysilane, butyltrimethoxysilane, butyltriethoxysilane, isobutyltrimethoxysilane, isobutyltriethoxysilane, allyltrimethoxysilane, allyltriethoxysilane, cyclopentyltrimethoxysilane, cyclopentyltriethoxysilane, cyclohexyltrimethoxysilane, cyclohexyltriethoxysilane, cyclohexenyltrimethoxysilane, cyclohexenyltriethoxysilane, phenyltrimethoxysilane, phenyltriethoxysilane, benzyltrimethoxysilane, benzyltriethoxysilane, phenethyltrimethoxysilane, phenethyltriethoxysilane, dimethyldimethoxysilane, dimethyldiethoxysilane, diethyldimethoxysilane, diethyldiethoxysilane, methylethyldimethoxysilane, methylethyldiethoxysilane, dipropyldimethoxysilane, dibutyldimethoxysilane, methylphenyldimethoxysilane, methylphenyldiethoxysilane, trimethylmethoxysilane, dimethylethylmethoxysilane, dimethylphenylmethoxysilane, dimethylbenzylmethoxysilane, and dimethylphenethylmethoxysilane.

Another example of the organic group represented by R^{a}, R^{b}, and R^{c} corresponding to the compound exemplified above as the hydrolyzable monomer (Sm) is an organic group having one or more of a carbon-oxygen single bonds and a carbon-oxygen double bond. Specifically, it is an organic group having one or more groups selected from the group consisting of an ether bond, an ester bond, an alkoxy group, a hydroxy group, etc. Examples thereof include those represented by the following general formula (Sm-R). By including such organic groups, the thermosetting properties can be improved; therefore, it is suitable for the photomask blank of the present invention. Also, the adhesion to the upper layer photoresist film is improved, allowing a highly rectangular resist pattern to be obtained after development.

(P-Q₁-(S₁)ᵥ₁-Q₂-)ᵤ-(T)ᵥ₂-Q₃-(S₂)ᵥ₃-Q₄- (Sm-R)

In the general formula (Sm-R), P is a hydrogen atom, a cyclic ether group, a hydroxyl group, an alkoxy group having 1 to 4 carbon atoms, an alkylcarbonyloxy group having 1 to 6 carbon atoms, or an alkylcarbonyl group having 1 to 6 carbon atoms; Q₁, Q₂, Q₃, and Q₄ are each independently -C_{q}H_{(2q-p)}Pₚ- (wherein P is the same as above, "p" is an integer from 0 to 3, and "q" is an integer of 0 to 10 (however, q=0 represents a single bond) ); "u" is an integer from 0 to 3; S₁ and S₂ and each independently represent -O-, -CO-, -OCO-, -COO- or - OCOO-. v1, v2, and v3 each independently represent 0 or 1. T is a divalent group selected from the group consisting of a divalent atom other than carbon, an alicyclic ring, an aromatic ring, or a heterocyclic ring. As T, examples of an alicyclic ring that may contain heteroatoms, such as oxygen atoms, an aromatic ring, or a heterocyclic ring, are shown below. At T, the positions to which Q₂ or Q₃ are bonded are not particularly limited, but can be selected appropriately taking into consideration reactivity due to steric factors, availability of commercially available reagents used in the reaction, etc.

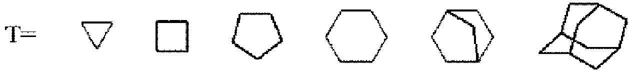

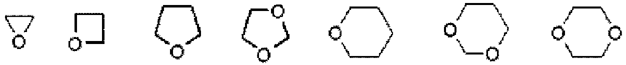

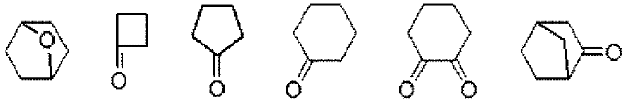

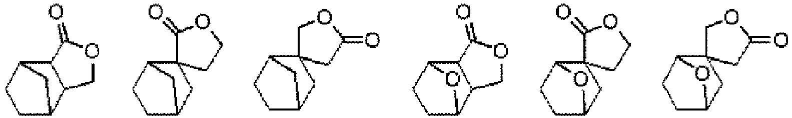

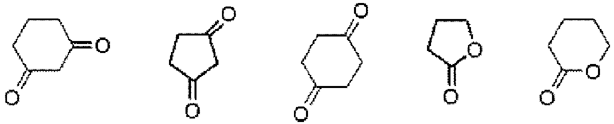

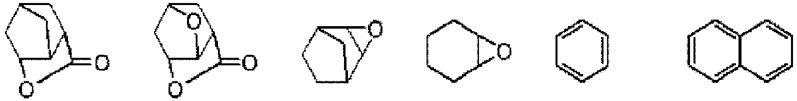

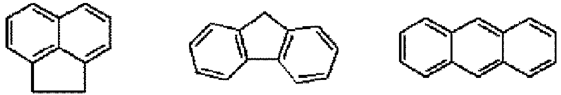

Preferred examples of the organic group having one or more of a carbon-oxygen single bond or a carbon-oxygen double bond in the general formula (Sm-R) include the followings. It should be noted that, in the following formula, (Si) has been written to indicate the bonding site with Si.

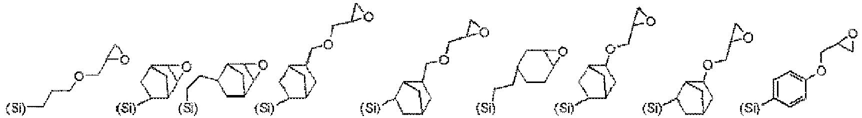

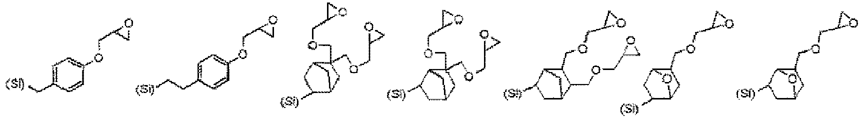

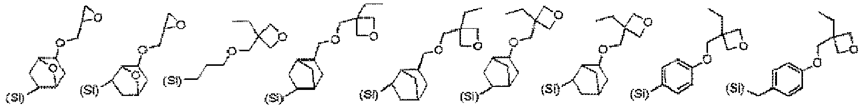

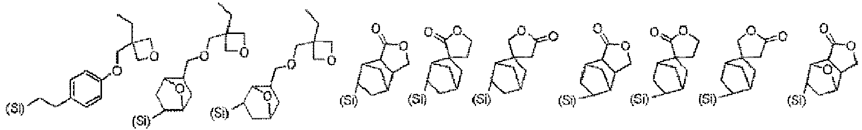

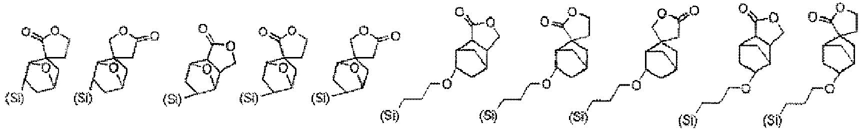

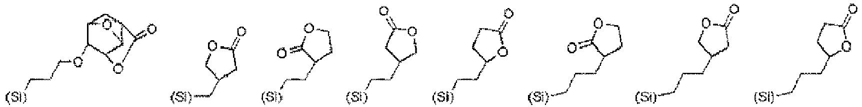

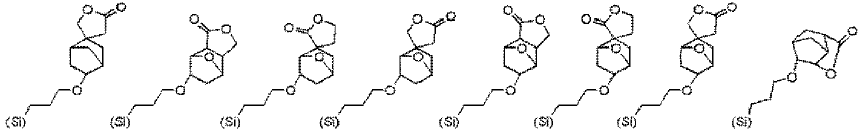

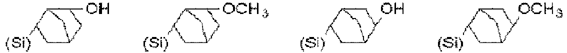

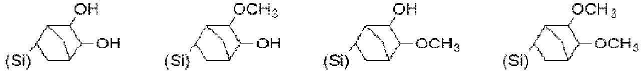

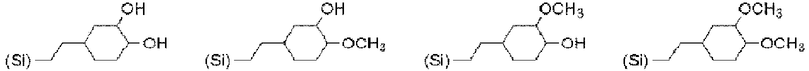

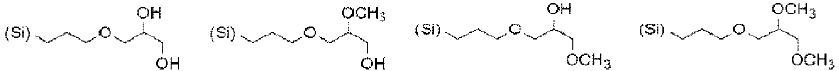

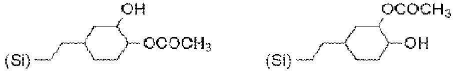

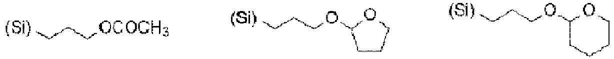

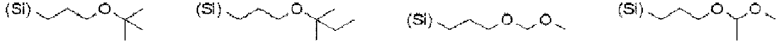

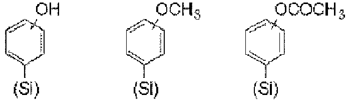

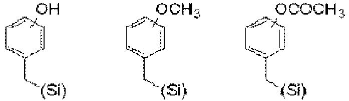

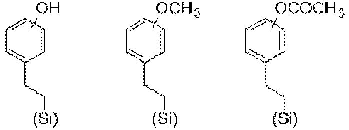

Moreover, as an example of the organic group for R^{a}, R^{b}, and R^{c}, an organic group containing a silicon-silicon bond can also be used. Specifically, the followings can be included.

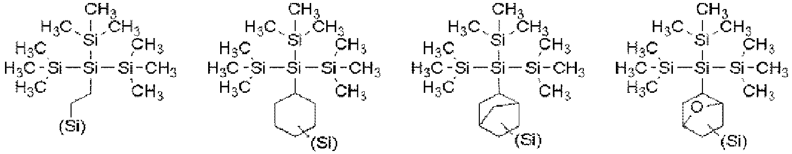

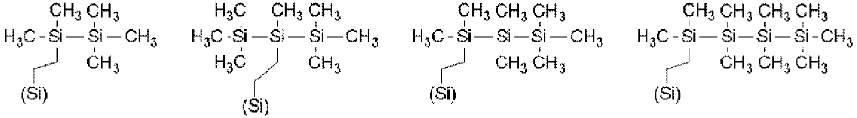

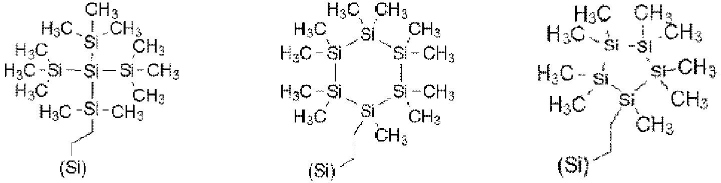

Furthermore, an organic group having a protecting group which decompose due to acids can also be used as an example of the organic group for R^{a}, R^{b}, and R^{c}. Specific examples include the organic groups listed in paragraphs [0043] to [0048] of JP2013-167669A and the organic groups obtained from silicon compounds listed in paragraph [0056] of JP2013-224279A.

Furthermore, an organic group having a fluorine atom can also be used as an example of the organic group for R^{a}, R^{b}, and R^{c}. Specifically, organic groups obtained from silicon compounds shown in paragraphs [0059] to [0065] of JP2012-53253A can be included.

The above hydrolyzable monomer (Sm) has one, two, or three chlorine, bromine, or iodine, or acetoxy, methoxy, ethoxy, propoxy, or butoxy groups bonded to the silicon atom represented by (Si) in the above partial structure as a hydrolyzable group.

### [Method for synthesizing thermally crosslinkable polysiloxane (Sx)]

### (Synthesis method 1: method using acid catalyst)

The thermally crosslinkable polysiloxane (Sx) used in the present invention can be produced by, for example, performing hydrolytic condensation of one or more hydrolyzable monomers (Sm) in the presence of an acid catalyst.

Examples of acid catalysts used at this time include organic acids such as formic acid, acetic acid, oxalic acid, maleic acid, methanesulfonic acid, benzenesulfonic acid, and toluenesulfonic acid, and inorganic acids such as hydrofluoric acid, hydrochloric acid, hydrobromic acid, sulfuric acid, nitric acid, perchloric acid, and phosphoric acid. The amount of catalyst used is 1×10⁻⁶ to 10 mol, preferably 1×10⁻⁵ to 5 mol, and more preferably 1×10⁻⁴ to 1 mol, per mol of monomer.

The amount of water added when obtaining thermally crosslinkable polysiloxane (Sx) from these monomers by virtue of hydrolytic condensation is 0.01 to 100 mol, more preferably 0.05 to 50 mol, and further preferably 0.1 to 30 mol, per mol of hydrolyzable substituent bonded to the monomer. If it is 100 mol or less, the apparatus used for the reaction will be small, which is economical.

One example of a method of operation is a method in which a monomer is added to an aqueous solution of a catalyst to initiate a hydrolytic condensation reaction. At this time, an organic solvent may be added to the aqueous solution of catalyst, the monomer may be diluted with an organic solvent, or both may be performed. The reaction temperature is 0 to 100°C, and preferably 5 to 50°C. It is preferable to keep the temperature at 5 to 50°C when dropping the monomer, and then mature it at 20 to 50°C.

Preferable examples of organic solvents that can be added to the aqueous solution of catalyst or dilute the monomers include methanol, ethanol, 1-propanol, 2-propanol, 1-butanol, 2-butanol, 2-methyl-1-propanol, acetone, acetonitrile, tetrahydrofuran, toluene, hexane, ethyl acetate, methyl ethyl ketone, methyl isobutyl ketone, cyclohexanone, methyl amyl ketone, butanediol monomethyl ether, propylene glycol monomethyl ether, ethylene glycol monomethyl ether, butanediol monoethyl ether, propylene glycol monoethyl ether, ethylene glycol monoethyl ether, propylene glycol dimethyl ether, diethylene glycol dimethyl ether, propylene glycol monomethyl ether acetate, propylene glycol monoethyl ether acetate, ethyl pyruvate, butyl acetate, methyl 3-methoxypropionate, ethyl 3-ethoxypropionate, tert-butyl acetate, t-butyl propionate, propylene glycol mono-t-butyl ether acetate, γ-butyrolactone, and mixtures thereof.

The preferred ones among these solvents are the water-soluble solvents. Examples include alcohols such as methanol, ethanol, 1-propanol, and 2-propanol; polyhydric alcohols such as ethylene glycol and propylene glycol; polyhydric alcohol condensate derivatives such as butanediol monomethyl ether, propylene glycol monomethyl ether, ethylene glycol monomethyl ether, butanediol monoethyl ether, propylene glycol monoethyl ether, ethylene glycol monoethyl ether, butanediol monopropyl ether, propylene glycol monopropyl ether, and ethylene glycol monopropyl ether; acetone; acetonitrile; and tetrahydrofuran. Among these, solvent with a boiling point of 100°C or less are particularly preferred.

The amount of organic solvent used is preferably 0 to 1,000 ml, and particularly preferably 0 to 500 ml, per mol of monomer. The less organic solvent is used, the smaller the reaction vessel is, which is economical.

Thereafter, if necessary, a neutralization reaction of the catalyst is performed to obtain an aqueous solution of reaction mixture. At this time, the amount of alkaline substance that can be used for neutralization is preferably 0.1 to 2 equivalents relative to the acid used as the catalyst. This alkaline substance may be any substance as long as it exhibits alkalinity in water.

Subsequently, by-products such as alcohol produced in the hydrolysis condensation reaction are preferably removed from the reaction mixture by vacuum removal, etc. The temperature to which the reaction mixture is heated at this time depends on the type of organic solvent added and the alcohol generated by the reaction, but is preferably 0 to 100°C, more preferably 10 to 90°C, and further preferably 15 to 80°C. The degree of pressure reduction at this time varies depending on the type of organic solvent and alcohol to be removed, the exhaust equipment, the condensation equipment, and the heating temperature, but is preferably atmospheric pressure or less, more preferably 80 kPa or less in absolute pressure, and further preferably 50 kPa or less in absolute pressure. Although it is difficult to accurately know the amount of alcohol to be removed at this time, it is desirable that approximately 80% by mass or more of the generated alcohol be removed.

Next, the acid catalyst used in the hydrolytic condensation may be removed from the reaction mixture. As a method for removing the acid catalyst, water and a thermally crosslinkable polysiloxane solution are mixed, and the thermally crosslinkable polysiloxane is extracted with an organic solvent. The organic solvent used at this time is preferably a solvent that can dissolve the thermally crosslinkable polysiloxane and separates into two layers when mixed with water. Examples include methanol, ethanol, 1-propanol, 2-propanol, 1-butanol, 2-butanol, 2-methyl-1-propanol, acetone, tetrahydrofuran, toluene, hexane, ethyl acetate, cyclohexanone, methyl amyl ketone, butanediol monomethyl ether, propylene glycol monomethyl ether, ethylene glycol monomethyl ether, butanediol monoethyl ether, propylene glycol monoethyl ether, ethylene glycol monoethyl ether, butanediol monopropyl ether, propylene glycol monopropyl ether, ethylene glycol monopropyl ether, propylene glycol dimethyl ether, diethylene glycol dimethyl ether, propylene glycol monomethyl ether acetate, propylene glycol monoethyl ether acetate, ethyl pyruvate, butyl acetate, methyl 3-methoxypropionate, ethyl 3-ethoxypropionate, t-butyl acetate, t-butyl propionate, propylene glycol mono t-butyl ether acetate, γ-butyrolactone, methyl isobutyl ketone, cyclopentyl methyl ether, and mixtures thereof.

Furthermore, it is also possible to use a mixture of a water-soluble organic solvent and a poorly water-soluble organic solvent. For example, a mixture of methanol and ethyl acetate, a mixture of ethanol and ethyl acetate, a mixture of 1-propanol and ethyl acetate, a mixture of 2-propanol and ethyl acetate, a mixture of butanediol monomethyl ether and ethyl acetate, a mixture of propylene glycol monomethyl ether and ethyl acetate, a mixture of ethylene glycol monomethyl ether and ethyl acetate, a mixture of butanediol monoethyl ether and ethyl acetate, a mixture of propylene glycol monoethyl ether and ethyl acetate, a mixture of ethylene glycol monoethyl ether and ethyl acetate, a mixture of butanediol monopropyl ether and ethyl acetate, a mixture of propylene glycol monopropyl ether and ethyl acetate, a mixture of ethylene glycol monopropyl ether and ethyl acetate, a mixture of methanol and methyl isobutyl ketone, a mixture of ethanol and methyl isobutyl ketone, a mixture of 1-propanol and methyl isobutyl ketone, a mixture of 2-propanol and methyl isobutyl ketone, a mixture of propylene glycol monomethyl ether and methyl isobutyl ketone, a mixture of ethylene glycol monomethyl ether and methyl isobutyl ketone, a mixture of propylene glycol monoethyl ether and methyl isobutyl ketone, a mixture of ethylene glycol monoethyl ether and methyl isobutyl ketone, a mixture of propylene glycol monopropyl ether and methyl isobutyl ketone, a mixture of ethylene glycol monopropyl ether and methyl isobutyl ketone, a mixture of methanol and cyclopentyl methyl ether, a mixture of ethanol and cyclopentyl methyl ether, a mixture of 1-propanol and cyclopentyl methyl ether, a mixture of 2-propanol and cyclopentyl methyl ether, a mixture of propylene glycol monomethyl ether and cyclopentyl methyl ether, a mixture of ethylene glycol monomethyl ether and cyclopentyl methyl ether, a mixture of propylene glycol monoethyl ether and cyclopentyl methyl ether, a mixture of ethylene glycol monoethyl ether and cyclopentyl methyl ether, a mixture of propylene glycol monopropyl ether and cyclopentyl methyl ether, a mixture of ethylene glycol monopropyl ether andcyclopentyl methyl ether, a mixture of methanol and propylene glycol methyl ether acetate, a mixture of ethanol-propylene glycol methyl ether acetate, a mixture of 1-propanol and propylene glycol methyl ether acetate, a mixture of 2-propanol and propylene glycol methyl ether acetate, a mixture of propylene glycol monomethyl ether and propylene glycol methyl ether acetate, a mixture of ethylene glycol monomethyl ether and propylene glycol methyl ether acetate, a mixture of propylene glycol monoethyl ether and propylene glycol methyl ether acetate, a mixture of ethylene glycol monoethyl ether and propylene glycol methyl ether acetate, a mixture of propylene glycol monopropyl ether and propylene glycol methyl ether acetate, a mixture of ethylene glycol monopropyl ether and propylene glycol methyl ether acetate, etc. are preferred, but the combinations are not limited thereto.

It should be noted that the mixing ratio of the water-soluble organic solvent and the poorly water-soluble organic solvent is selected as appropriate, but is, for example, 0.1 to 1,000 parts by mass, preferably 1 to 500 parts by mass, and more preferably 2 to 100 parts by mass of the water-soluble organic solvent to 100 parts by mass of the poorly water-soluble organic solvent.

And then, washing with neutral water may be performed. As this water, what is usually called deionized water or ultrapure water may be used. The amount of water is preferably 0.01 to 100 L, more preferably 0.05 to 50 L, and further preferably 0.1 to 5 L per 1 L of thermally crosslinkable polysiloxane solution. For this washing method, both may be mixed in the same container, and then left to stand to separate the aqueous layer. The number of times for washing may be 1 time or more, but is preferably about 1 to 5 times, since washing 10 times or more will not necessarily provide the same effects as just washing.

Other methods for removing the acid catalyst include a method using an ion exchange resin and a method in which the acid catalyst is removed after neutralization with an epoxy compound such as ethylene oxide or propylene oxide. These methods can be appropriately selected depending on the acid catalyst used in the reaction.

Due to the water washing operation at this time, some of the thermally crosslinkable polysiloxane escapes into the water layer, and in some cases the effect is essentially the same as that of a fractionation operation, so the number of times of washing and the amount of washing water may be selected appropriately, taking account of the removal effects and the fractionation effects.

In both the thermally crosslinkable polysiloxane solution with residual acid catalyst and the thermally crosslinkable polysiloxane solution from which the acid catalyst has been removed, the final solvent is added and perform the solvent exchange under reduced pressure to obtain the desired thermally crosslinkable polysiloxane solution. The temperature for the solvent exchange depends on the type of reaction solvent and the extraction solvent to be removed, but is preferably 0 to 100°C, more preferably 10 to 90°C, and further preferably 15 to 50°C. The degree of pressure reduction at this time varies depending on the type of extraction solvent to be removed, the exhaust device, the condensing device, and the heating temperature, but is preferably atmospheric pressure or less, more preferably 80 kPa or less in absolute pressure, and further preferably 50 kPa in absolute pressure.

At this time, the thermally crosslinkable polysiloxane may become unstable due to a change in the solvent. This occurs due to the compatibility between the final solvent and the thermally crosslinkable polysiloxane, but in order to prevent this, a monohydric, dihydric, or higher alcohol having a cyclic ether as a substituent may be added as a stabilizer as described in paragraphs [0181] to [0182] of JP2009-126940A. The amount to be added is 0 to 25 parts by mass, preferably 0 to 15 parts by mass, and more preferably 0 to 5 parts by mass, based on 100 parts by mass of the thermally crosslinkable polysiloxane in the solution before solvent exchange. In the case where the alcohol is added, the amount is preferably 0.5 parts by mass or more. If necessary, a monohydric, dihydric, or higher alcohol having a cyclic ether as a substituent may be added to the solution before the solvent exchange to perform the solvent exchange operation.

If the thermally crosslinkable polysiloxane is concentrated above a certain concentration, there is the risk that the condensation reaction will proceed further so that the polysiloxane changes to a state where it cannot be redissolved in organic solvents. Therefore, the polysiloxane is preferably kept in a solution state with an appropriate concentration. Furthermore, if it is too diluted, the amount of solvent will be excessive. Therefore, so it is economical and preferable to keep it in a solution state with an appropriate concentration. The concentration at this time is preferably 0.1 to 20% by mass.

Preferred final solvents to be add to the thermally crosslinkable polysiloxane solution are alcohol-based solvents, and particularly preferred solvents include monoalkyl ether derivatives such as ethylene glycol, diethylene glycol, triethylene glycol, propylene glycol, dipropylene glycol, and butanediol. Specifically, butanediol monomethyl ether, propylene glycol monomethyl ether, ethylene glycol monomethyl ether, butanediol monoethyl ether, propylene glycol monoethyl ether, ethylene glycol monoethyl ether, butanediol monopropyl ether, propylene glycol monopropyl ether, ethylene glycol monopropyl ether, diacetone alcohol, etc. are preferred.

If these solvents are the main components, it is also possible to add a non-alcoholic solvent as an auxiliary solvent. Examples of the auxiliary solvent include acetone, tetrahydrofuran, toluene, hexane, ethyl acetate, cyclohexanone, methyl amyl ketone, propylene glycol dimethyl ether, diethylene glycol dimethyl ether, propylene glycol monomethyl ether acetate, propylene glycol monoethyl ether acetate, ethyl pyruvate, butyl acetate, methyl 3-methoxypropionate, ethyl 3-ethoxypropionate, t-butyl acetate, t-butyl propionate, propylene glycol mono t-butyl ether acetate, γ-butyrolactone, methyl isobutyl ketone, and cyclopentyl methyl ether.

Furthermore, as another example of a reaction operation using an acid catalyst, water or a water-containing organic solvent is added to a monomer or an solution of a monomer in organic solvent to initiate a hydrolysis reaction. At this time, the catalyst may be added to the monomer or the solution of the monomer in organic solvent, or may be added to the water or the water-containing organic solvent. The reaction temperature is 0 to 100°C, and preferably 10 to 50°C. A preferred method is a method where the mixture is heated to 10 to 50°C during the dropwise addition of water, and then raised the temperature to 20 to 50°C for maturing.

When an organic solvent is used, a water-soluble solvent is preferable, such as methanol, ethanol, 1-propanol, 2-propanol, 1-butanol, 2-butanol, 2-methyl-1-propanol, acetone, tetrahydrofuran, acetonitrile, polyhydric alcohol condensate derivatives such as butanediol monomethyl ether, propylene glycol monomethyl ether, ethylene glycol monomethyl ether, butanediol monoethyl ether, propylene glycol monoethyl ether, ethylene glycol monoethyl ether, butanediol monopropyl ether, propylene glycol monopropyl ether, ethylene glycol monopropyl ether, propylene glycol dimethyl ether, diethylene glycol dimethyl ether, propylene glycol monomethyl ether acetate, propylene glycol monoethyl ether acetate, propylene glycol monopropyl ether, and mixtures thereof.

The amount of organic solvent used is preferably 0 to 1,000 ml, and particularly preferably 0 to 500 ml, per mol of monomer. The less organic solvent is used, the smaller the reaction vessel will be, which is economical. The resulting reaction mixture can be post-treated in the same manner as described above to obtain a thermally crosslinkable polysiloxane.

### (Synthesis method 2: Method using an alkaline catalyst)

Furthermore, the thermally crosslinkable polysiloxane (Sx) can also be produced by performing hydrolytic condensation of one type or a mixture of two or more types of hydrolyzable monomers (Sm) in the presence of an alkali catalyst.

The alkali catalyst used includes, for example, methylamine, ethylamine, propylamine, butylamine, ethylenediamine, hexamethylenediamine, dimethylamine, diethylamine, ethylmethylamine, trimethylamine, triethylamine, tripropylamine, tributylamine, cyclohexylamine, dicyclohexylamine, monoethanolamine, diethanolamine, dimethylmonoethanolamine, monomethyldiethanolamine, triethanolamine, diazabicyclooctane, diazabicyclocyclononene, diazabicycloundecene, hexamethylenetetramine, aniline, N,N-dimethylaniline, pyridine, N,N-dimethylaminopyridine, pyrrole, piperazine, pyrrolidine, piperidine, picoline, tetramethylammonium hydroxide, choline hydroxide, tetrapropylammonium hydroxide, tetrabutylammonium hydroxide, ammonia, lithium hydroxide, sodium hydroxide, potassium hydroxide, barium hydroxide, calcium hydroxide, etc. The amount of the catalyst used is 1×10⁻⁶ mol to 10 mol, preferably 1×10⁻⁵ mol to 5 mol, and more preferably 1×10⁻⁴ to 1 mol, per mol of silicon monomer.

The amount of water added when obtaining thermally crosslinkable polysiloxane from the above monomer by hydrolytic condensation is preferably 0.1 to 50 mol per mol of hydrolyzable substituent bonded to the monomer. If it is 50 mol or less, the equipment used for the reaction will be small, which is economical.

One example of a method of operation is to add a monomer to an aqueous catalyst solution to initiate a hydrolytic condensation reaction. At this time, an organic solvent may be added to the aqueous catalyst solution, the monomer may be diluted with an organic solvent, or both may be performed. The reaction temperature is 0 to 100°C, and preferably 5 to 50°C. It is preferable to keep the temperature at 5 to 50°C when dropping the monomer, and then mature it at 20 to 50°C.

As an organic solvent that can be added to the aqueous solution of the alkaline catalyst or can dilute the monomer, the same organic solvents as those exemplified as solvents that can be added to the aqueous solution of the acid catalyst are preferably used. The amount of organic solvent to be used is preferably 0 to 1,000 ml per mol of monomer so that the reaction can be carried out economically.

Thereafter, if necessary, a neutralization reaction of the catalyst is performed to obtain an aqueous solution of the reaction mixture. At this time, the amount of acidic substance that can be used for neutralization is preferably 0.1 to 2 equivalents relative to the alkaline substance used as the catalyst. This acidic substance may be any substance as long as it exhibits acidity in water.

Subsequently, by-products such as alcohol produced in the hydrolysis condensation reaction are preferably removed from the reaction mixture by vacuum removal, etc. The temperature to which the reaction mixture is heated at this time depends on the organic solvent added and the type of alcohol generated by the reaction, but is preferably 0 to 100°C, more preferably 10 to 90°C, and further preferably 15 to 50°C. The degree of pressure reduction at this time varies depending on the type of organic solvent and alcohol to be removed, the exhaust device, the condensing device, and the heating temperature, but is preferably atmospheric pressure or less, more preferably 80 kPa or less in absolute pressure, and further preferably 50 kPa or less in absolute pressure. Although it is difficult to accurately know the amount of alcohol to be removed at this time, it is desirable that approximately 80% by mass or more of the produced alcohol be removed.

Next, in order to remove the alkali catalyst used for hydrolytic condensation, the thermally crosslinkable polysiloxane is extracted with an organic solvent. The organic solvent used at this time is preferably a solvent that can dissolve the thermally crosslinkable polysiloxane and separates into two layers when mixed with water. Examples include methanol, ethanol, 1-propanol, 2-propanol, 1-butanol, 2-butanol, 2-methyl-1-propanol, acetone, tetrahydrofuran, toluene, hexane, ethyl acetate, cyclohexanone, methyl amyl ketone, propylene glycol monomethyl ether, ethylene glycol monomethyl ether, propylene glycol monoethyl ether, ethylene glycol monoethyl ether, propylene glycol monopropyl ether, ethylene glycol monopropyl ether, propylene glycol dimethyl ether, diethylene glycol dimethyl ether, propylene glycol monomethyl ether acetate, propylene glycol monoethyl ether acetate, ethyl pyruvate, butyl acetate, methyl 3-methoxypropionate, ethyl 3-ethoxypropionate, t-butyl acetate, t-butyl propionate, propylene glycol mono t-butyl ether acetate, γ-butyrolactone, methyl isobutyl ketone, cyclopentyl methyl ethers, mixtures thereof, etc.

Furthermore, it is also possible to use a mixture of a water-soluble organic solvent and a poorly water-soluble organic solvent.

Specific examples of organic solvents used when removing alkali catalysts include the same organic solvents and the same mixtures of water-soluble organic solvents and water-resistant organic solvents as those specifically exemplified as those used when removing acid catalysts.

The mixing ratio of the water-soluble organic solvent and the poorly water-soluble organic solvent is selected as appropriate, but is 0.1 to 1,000 parts by mass, preferably 1 to 500 parts by mass, and more preferably 2 to 100 parts by mass of the water-soluble organic solvent, to 100 parts by mass of the poorly water-soluble organic solvent.

Then, it is washed with neutral water. As this water, what is usually called deionized water or ultrapure water may be used. The amount of water is 0.01 to 100 L, preferably 0.05 to 50 L, and more preferably 0.1 to 5 L, per 1 L of thermally crosslinkable polysiloxane solution. For this washing method, both may be mixed in the same container, then left to stand to separate the aqueous layer. The number of times for washing may be 1 time or more, but is preferably about 1 to 5 times, since washing 10 times or more will not necessarily provide the same effects as just washing.

A final solvent is added to the washed thermally crosslinkable polysiloxane solution, and the solvent is exchanged under reduced pressure to obtain the desired thermally crosslinkable polysiloxane solution. The temperature for solvent exchange at this time depends on the type of extraction solvent to be removed, but is preferably 0 to 100°C, more preferably 10 to 90°C, and further preferably 15 to 50°C. The degree of pressure reduction at this time varies depending on the type of extraction solvent to be removed, the exhaust equipment, the condensation equipment, and the heating temperature, but is preferably atmospheric pressure or less, more preferably 80 kPa in absolute pressure or less, and further preferably absolute pressure 50kPa or less.

Preferred chemicals to add to the thermally crosslinkable polysiloxane solution as the final solvent are alcoholic solvents, and particularly preferred are monoalkyl ethers such as ethylene glycol, diethylene glycol, and triethylene glycol, and monoalkyl ethers such as propylene glycol and dipropylene glycol. Specifically, propylene glycol monomethyl ether, ethylene glycol monomethyl ether, propylene glycol monoethyl ether, ethylene glycol monoethyl ether, propylene glycol monopropyl ether, ethylene glycol monopropyl ether, diacetone alcohol, etc. are preferred.

Furthermore, another example of a reaction operation using an alkali catalyst is to add water or a water-containing organic solvent to a monomer or an organic solution of a monomer to initiate a hydrolysis reaction. At this time, the catalyst may be added to the monomer or an organic solution of the monomer, or may be added to water or a water-containing organic solvent. The reaction temperature is 0 to 100°C, and preferably 10 to 50°C. A preferred method is a method where the mixture is heated to 10 to 50°C during the dropwise addition of water, and then raised the temperature to 20 to 50°C for maturing.

The organic solvent that can be used as the organic solution of the monomer or the water-containing organic solvent is preferably a water-soluble solvent, such as methanol, ethanol, 1-propanol, 2-propanol, 1-butanol, 2-butanol, 2-methyl-1-propanol, acetone, tetrahydrofuran, acetonitrile, polyhydric alcohol condensate derivatives such as propylene glycol monomethyl ether, ethylene glycol monomethyl ether, propylene glycol monoethyl ether, ethylene glycol monoethyl ether, propylene glycol monopropyl ether, ethylene glycol monopropyl ether, propylene glycol dimethyl ether, diethylene glycol dimethyl ether, propylene glycol monomethyl ether acetate, propylene glycol monoethyl ether acetate, and propylene glycol monopropyl ether, and mixtures thereof.

The molecular weight of the thermally crosslinkable polysiloxane obtained by the above synthesis method 1 or 2 can be adjusted not only by the selection of monomers but also by controlling the reaction conditions during polymerization, but the weight average molecular weight used is preferably 100,000 or less, more 200 to 50,000, and further preferably 300 to 30,000. If the weight average molecular weight is 100,000 or less, no foreign matter or uneven coating will occur. The data regarding the weight average molecular weight is expressed by gel permeation chromatography (GPC) using RI as a detector and tetrahydrofuran as an eluent, using polystyrene as a standard substance, and expressing the molecular weight on polystyrene basis.

### (Crosslinking catalyst)

One or two crosslinking catalysts may be further blended into the composition for forming a silicon-containing hard mask film. Examples of crosslinking catalysts that can be blended include compounds represented by the following general formula (Xc0). By including such crosslinking catalysts, the thermosetting properties can be further improved.

LₐH_{b}A (Xc0)

wherein L is lithium, sodium, potassium, rubidium, cesium, sulfonium, iodonium, phosphonium, or ammonium. A is a non-nucleophilic counter ion. "a" is an integer that is 1 or more, "b" is an integer that is 0 or 1 or more, and a+b is the valence of the non-nucleophilic counter ion.

Specific crosslinking catalysts used in the present invention indicated as general formula (Xc0) include, for example, sulfonium salts of the following general formula (Xc-1), iodonium salts of the following general formula (Xc-2), phosphonium salts of the following general formula (Xc-3), ammonium salts of the following general formula (Xc-4), alkali metal salts, etc., and polysiloxanes (Xc-10) having ammonium salts, sulfonium salts, phosphonium salts, and iodonium salts as part of their structure. Specifically, materials described in paragraphs [0124] to [0163] of JP2020-118960A can be added. 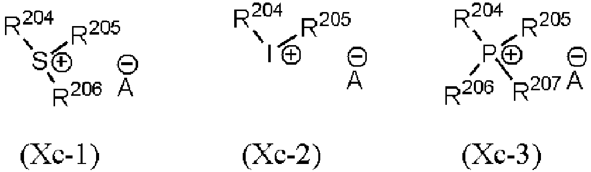 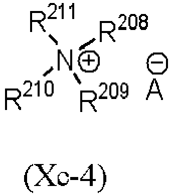 In the formulae, R²⁰⁴, R²⁰⁵, R²⁰⁶, and R²⁰⁷ are each a linear, branched, or cyclic alkyl group, alkenyl group, oxoalkyl group, or oxoalkenyl group having 1 to 12 carbon atoms, a substituted or unsubstituted aryl group having 6 to 20 carbon atoms, or an aralkyl group or an aryloxoalkyl groups having 7 to 12 carbon atoms, and some or all of the hydrogen atoms of these groups may be substituted with an alkoxy group, etc. Furthermore, R²⁰⁵ and R²⁰⁶ may form a ring, and if they form a ring, R²⁰⁵ and R²⁰⁶ each represent an alkylene group having 1 to 6 carbon atoms. A⁻ represents a non-nucleophilic counter ion. R²⁰⁸, R²⁰⁹, R²¹⁰, and R²¹¹ are the same as R²⁰⁴, R²⁰⁵, R²⁰⁶, and R²⁰⁷, but may be hydrogen atoms. R²⁰¹ and R²⁰⁹, or R²⁰¹, R²⁰⁹, and R²¹⁰ may form a ring, and if they form a ring, R²⁰⁸ and R²⁰⁹, or R²⁰⁸, R²⁰⁹ and R²¹⁰ represent an alkylene group having 3 to 10 carbon atoms.

As a crosslinking catalyst, one of the crosslinking catalysts (Xc-1), (Xc-2), (Xc-3), (Xc-4), and (Xc-10) can be used or a combination of two or more thereof can be used. The amount of the crosslinking catalyst added is preferably 0.01 to 50 parts by mass, and more preferably 0.1 to 40 parts by mass, per 100 parts by mass of the base polymer (for example, a thermally crosslinkable polysiloxane (Sx) obtained by the above method) .

### [Other materials]

The following ingredients may be blended into the composition for forming a silicon-containing hard mask film.

### (Acid generator)

One or two acid generators may be further blended into the composition for forming a silicon-containing hard mask film. As the acid generator, any substance that acts as an acid precursor, such as a thermal acid generator, a photoacid generator, or an acid multiplying agent, may be used, but in the present invention, the acid generator to be blended is more preferably a sulfonium salt as a photoacid generator that generates acid by the action of high energy rays. Specifically, materials described in paragraphs [0061] to [0085] of JP 2007-199653 A can be added, but it is not limited thereto.

As the acid generator, one compound can be used alone or a combination of two or more compounds can be used. When adding an acid generator, the amount added is preferably 0.05 to 50 parts, and more preferably 0.1 to 10 parts, per 100 parts of thermally crosslinkable polysiloxane.

### (Crosslinking agent)

A crosslinking agent may be further added to the composition for forming a silicon-containing hard mask film in order to improve the thermosetting properties. The crosslinking agent is not particularly limited, and a wide variety of known crosslinking agents can be used. Examples include melamine-based crosslinking agents, glycoluril-based crosslinking agents, benzoguanamine-based crosslinking agents, urea-based crosslinking agents, β-hydroxyalkylamide-based crosslinking agents, isocyanurate-based crosslinking agents, aziridine-based crosslinking agents, oxazoline-based crosslinking agents, epoxy-based crosslinking agents, and phenol-based crosslinking agents. As the crosslinking agent, one compound can be used alone or a combination of two or more compounds can be used. If a crosslinking agent is added, the amount added is preferably 5 to 50 parts, more preferably 10 to 40 parts, and further preferably 10 to 30 parts, per 100 parts of the composition for forming a silicon-containing hard mask film.

### (Organic acid)

In order to improve the stability of the composition for forming a silicon-containing hard mask film, it is preferable to add a monovalent or divalent or higher organic acid having 1 to 30 carbon atoms. Examples of the acids added at this time include formic acid, acetic acid, propionic acid, butanoic acid, pentanoic acid, hexanoic acid, heptanoic acid, octanoic acid, nonanoic acid, decanoic acid, oleic acid, stearic acid, linoleic acid, linolenic acid, benzoic acid, phthalic acid, isophthalic acid, terephthalic acid, salicylic acid, trifluoroacetic acid, monochloroacetic acid, dichloroacetic acid, trichloroacetic acid, oxalic acid, malonic acid, methylmalonic acid, ethylmalonic acid, propylmalonic acid, butylmalonic acid, dimethylmalonic acid, diethylmalonic acid, succinic acid, methylsuccinic acid, glutaric acid, adipic acid, itaconic acid, maleic acid, fumaric acid, citraconic acid, citric acid, etc. Particularly preferred are oxalic acid, maleic acid, formic acid, acetic acid, propionic acid, citric acid, etc. Moreover, in order to maintain stability, two or more types of acids may be used in combination.

The amount of the organic acid added is 0.001 to 25 parts by mass, preferably 0.01 to 15 parts by mass, and more preferably 0.1 to 5 parts by mass, based on 100 parts by mass of the thermally crosslinkable polysiloxane contained in the composition for forming a silicon-containing hard mask film.

Alternatively, the above organic acid is blended so that the pH converted into the pH of the composition for forming a silicon-containing hard mask film is preferably 0 ≤ pH ≤ 7, more preferably 0.3 ≤ pH ≤ 6.5, and further preferably 0.5 ≤ pH ≤ 6.

### (Solvent)

The composition for forming a silicon-containing hard mask film may further contain a coating solvent in order to improve coatability.

As the solvent used as a coating solvent of the composition for forming a silicon-containing hard mask film, the solvent used in the manufacturing of the silicon-containing compound is preferably used as is, and monoalkyl ethers such as ethylene glycol, diethylene glycol, and triethylene glycol, and monoalkyl ethers such as propylene glycol and dipropylene glycol are particularly preferably used. Specifically, an organic solvent selected from propylene glycol monomethyl ether, ethylene glycol monomethyl ether, propylene glycol monoethyl ether, ethylene glycol monoethyl ether, propylene glycol monopropyl ether, and ethylene glycol monopropyl ether is preferable, and they can also be used for additional dilution as necessary.

In addition to the above-mentioned solvents, known stabilizing solvent components such as water can be added. In order to form a silicon oxide based material layer with a thickness of 1 to 10 nm on a 152 mm (6 inch) square photomask blank, the amount of the total solvent including water used is preferably 1,000 to 250,000 parts by mass, and particularly preferably 10,000 to 200,000 parts by mass, per 100 parts by mass of the thermally crosslinkable polysiloxane.

### (Stabilizer)

Additionally, a stabilizer may be added to the composition for forming a silicon-containing hard mask film. As a stabilizer, a monohydric, dihydric, or higher alcohol having a cyclic ether as a substituent may be added. In particular, the stability of the composition for forming a silicon-containing hard mask film can be improved by adding the stabilizers described in paragraphs [0181] to [0182] of JP 2009-126940A.

The amount of stabilizer used is preferably 0 to 25 parts by mass, and particularly preferably 0 to 5 parts by mass, per 100 parts by mass of the thermally crosslinkable polysiloxane (Sx) that is the base polymer, but if one is added, the amount is preferably 0.5 part by mass or more.

### (Surfactant)

Furthermore, a surfactant can be blended into the composition as necessary. As such substance, specifically, the materials described in paragraph [0185] of JP 2009-126940 A can be added.

The amount of the surfactant used is preferably 0 to 10 parts by mass, and particularly preferably 0 to 5 parts by mass, per 100 parts by mass of the thermally crosslinkable polysiloxane (Sx) that is the base polymer.

### [Photoresist film]

A photoresist film is formed on the silicon-containing hard mask film. The resist used here is selected depending on the pattern exposure method. In order to form a fine pattern using the photomask blank of the present invention, a method using electron beam exposure is generally used, so a chemically amplified electron beam resist using an aromatic resin is generally used. Depending on the type of pattern, positive or negative resists are selected. This resist film is subjected to pattern-irradiation with an electron beam, and then undergoes a post-irradiation heating and development process appropriate for the resist, and a resist pattern is obtained.

Since the photomask blank according to the present invention described above contains a silicon-containing hard mask film that is useful as a hard mask, fine resist patterns can be transferred to the absorber layer with high accuracy. In addition, since the silicon-containing hard mask film can be formed within the temperature range of 50°C to 180°C, the transfer accuracy of the resist pattern can be improved without inducing interlayer mixing of the multilayer reflective film layers. That is, by using the photomask blank of the present invention, it is possible to provide a photomask having an absorber layer, wherein a fine pattern is formed with high accuracy without degrading the EUV-light reflectivity. That is, the photomask blank of the present invention is a photomask blank containing a silicon-containing hard mask film, the silicon-containing hard mask being able to function as a hard mask when the absorber layer is being processed by dry etching, and also to contribute to improving the resolution of a resist pattern.

### <Method for manufacturing photomask blank>

The method for manufacturing a photomask blank of the present invention comprises,
a step of providing a substrate;
a step of forming a multilayer reflective film layer that reflects an EUV light on the substrate;
a step of forming an absorber layer that absorbs the EUV light on the multilayer reflective film layer;
a step of applying a composition for forming a silicon-containing hard mask film directly or indirectly onto the absorber layer, the composition for forming a silicon-containing hard mask film being to cure at a temperature of 50°C or higher and 180°C or lower, to obtain a coating film, and curing the coating film at a temperature of 50°C or higher and 180°C or lower so as to form a silicone-containing hard mask film; and
a step of forming a photoresist film on the silicon-containing hard mask film.

The multilayer reflective film layer, the optional protective film, the absorber layer, the optional first layer of the hard mask (etching mask film), and the optional conductive film, each of which has been described above, can be formed by, for example, ion beam sputtering or magnetron sputtering.

The silicon-containing hard mask film is formed by applying a composition for forming a silicon-containing hard mask film (for example, the composition for forming a silicon-containing hard mask film) being to cure at a temperature of 50°C or more and 180°C or less, for example, directly or indirectly onto the absorber layer by a spin coating method, to obtain a coating film, then curing the composition at a temperature of 50°C or more and 180°C or less.

After forming the coating film by a spin coating method, etc., the coated film is baked to evaporate the organic solvent and cause curing. The baking temperature is preferably 50°C to 180°C, more preferably 80°C to 170°C, and further preferably 100°C to 150°C. The baking time is preferably 10 to 3,600 seconds, more preferably 300 to 2,400 seconds, and further preferably 600 to 1,200 seconds.

Under such baking conditions, a cured film of a silicon-containing hard mask film containing a sufficient density of Si-O-Si crosslinks can be formed directly or indirectly on an absorber layer without disturbing the periodic structure of the multilayer reflective film formed as the lower layer for the silicon-containing hard mask film; therefore, high etching resistance to the chlorine-based dry etching conditions can be obtained.

The thickness of the silicon-containing hard mask film depends on the thickness of the resist film formed as the upper layer for the silicon-containing hard mask and the thickness of the first layer of the hard mask film formed on the lower layer; however, it is preferably 1 to 50 nm, more preferably 5 to 30 nm, and particularly preferably 10 to 25 nm. Such a film thickness range provides sufficient etching resistance, making it possible to transfer the resist pattern to the absorber layer or the first layer of the hard mask film with high accuracy.

The lower limit of the silicon content in the silicon-containing hard mask film is preferably 5% or more, more preferably 10% or more, and further preferably 30% or more. A film containing silicon at such a ratio has excellent curing properties, making it possible to more reliably provide a silicon-containing hard mask film curing at a temperature of 50°C or more and 180°C or less. high etching resistance to the chlorine-based dry etching conditions can also be provided.

The upper limit of the silicon content in the silicon-containing hard mask film is preferably 50% or less, and more preferably 45% or less. With a film containing silicon at such a ratio, for example, the silicon-containing hard mask film remaining on the Cr-containing hard mask film pattern can be easily removed after the Cr-containing hard mask is dry etched.

The photoresist film can be formed by a coating method such as a spin coating method.

By virtue of the method for manufacturing a photomask blank according to the present invention described above, the photomask blank according to the present invention described above can be manufactured. However, the photomask blank of the present invention can also be manufactured by methods other than the manufacturing method described above.

### <Method for processing photomask blank>

The method for processing a photomask blank of the present invention comprises:
(i-1) a step of forming a photoresist pattern on the photoresist film wherein the photomask blank of the present invention is irradiated with an electron beam, and then a development is performed with a developer;
(i-2) a step of forming a silicon-containing film pattern on the silicon-containing hard mask film by etching the silicon-containing hard mask while using the photoresist pattern as a mask; and
(i-3) a step of directly or indirectly processing the absorber layer by performing etching while using the silicon-containing film pattern as a mask.

Such a method for processing of photomask blank uses a silicon-containing hard mask film as a hard mask having better dry-etching resistance to chlorine-based gases than a photoresist film, so the resist pattern can be transferred to the absorber layer of the photomask blank with high accuracy. In addition, since the silicon-containing hard mask film can be formed within the temperature range of 50°C to 180°C, the transfer accuracy of the resist pattern can be improved without inducing interlayer mixing of the multilayer reflective film layer. That is, by using the method for processing the photomask blank according to the present invention, it is possible to provide a photomask having an absorber layer, wherein a fine pattern is formed with high accuracy without degrading the EUV-light reflectivity.

A specific example of the method for processing the photomask blanks according to the present invention is described below.

First, the following are formed: a substrate; a multilayer reflective film layer reflecting the exposure light, which is EUV light, on the substrate; a protective film for protecting the multilayer reflective film layer on the multilayer reflective film layer; an absorber layer absorbing the exposure light, on the protective film; and a Cr-containing hard mask film that functions as the first layer of a hard mask when the absorber layer is patterned by dry etching, on the absorber layer.

Next, the composition for forming a silicon-containing hard mask film is applied onto the silicon-containing hard mask film, and baked at a temperature of 50°C or more and 180°C or less to form a cured film of the silicon-containing hard mask film. That is, a silicon-containing hard mask film is directly or indirectly formed on the absorber layer. Then, a photoresist film is formed on the silicon-containing hard mask film. Thus, a photomask blank is obtained.

The resist film of this photomask blank is irradiated with an electron beam by pattern irradiation, and after heating and development processes, a resist pattern is formed.

The resulting resist pattern is first transferred to a silicon-containing hard mask film by dry etching. For the dry etching conditions, commonly used conditions for fluorine-based dry etching by a fluorine-containing gas can be used. Fluorine-containing gases include fluorine gas, gases containing carbon and fluorine such as CF₄, CHF₃, C₂F₆, and gases containing sulfur and fluorine such as SF₆. Furthermore, a mixed gas consisting of a gas not containing fluorine, such as helium or nitrogen, and a gas containing fluorine may be used. In addition, gases such as oxygen may be added as necessary.

Next, the photoresist is stripped or left in place, and the pattern is transferred to a Cr-containing hard mask film while using the resulting silicon-containing hard mask film pattern as a hard mask. The dry etching used here can be chlorine-based dry etching. For example, commonly used chlorine-based dry etching containing oxygen can be used. For the dry etching conditions, for example, dry etching can be performed using a gas whose mixing ratio of chlorine gas and oxygen gas (Cl₂ gas : O₂ gas) is a volumetric flow ratio of 1:2 to 20:1, and that is, as necessary, mixed with an inert gas such as helium. The silicon-containing hard mask film has higher resistance to chlorine-based dry-etching compared to the resist film, and therefore by using the silicon-containing hard mask film as a hard mask, the resist pattern can be transferred to a Cr hard mask with high accuracy.

while using Cr hard mask film pattern as a hard mask, the pattern is transferred to the absorber layer. The dry etching used here can be fluorine-based dry etching under commonly used fluorine-containing gas conditions. Fluorine-containing gases include fluorine gas, gases containing carbon and fluorine such as CF₄, CHF₃, C₂F₆, and gases containing sulfur and fluorine such as SF₆. Furthermore, a mixed gas consisting of a gas not containing fluorine, such as helium or nitrogen, and a gas containing fluorine may be used. In addition, gases such as oxygen may be added as necessary. The silicon-containing hard mask film remaining on the Cr hard mask film can be removed by the above-mentioned fluorine-based dry etching. Furthermore, before the above-mentioned fluorine-based dry etching, wet etching may be performed in the same manner as for general SOG films.

Chlorine-based dry etching can be used to remove the Cr hard mask film remaining on the absorber layer. The protective film formed on the multilayer reflective film is resistant to chlorine-based dry etching, making it possible to remove the Cr hard mask film without damaging the multilayer reflective film.

In the above, an example has been shown wherein a silicon-containing hard mask film is indirectly formed on an absorber layer through a Cr hard mask film, but in the present invention, a silicon-containing hard mask film may be formed directly on an absorber layer. In this case, the silicon-containing hard mask film pattern can be used as a mask for etching the absorber layer.

### EXAMPLES

Hereinafter, the present invention will be described more specifically with reference to Synthesis Examples, Examples and Comparative Examples. However, the present invention is not limited thereto. In the following examples, % indicates % by mass, and molecular weight Mw is a weight-average molecular weight based on GPC measurement in terms of polystyrene.

### [Synthesis Example 1]

A mixture of 30.6 g of compound (101), 38.1 g of compound (102) and 5.9 g of compound (110) was added to a mixture of 120 g of methanol, 0.1 g of 10% nitric acid and 60 g of deionized water, and the temperature of the mixture was kept 40°C for 12 hours to perform hydrolytic condensation. After the reaction was completed, 600 g of PGEE (propylene glycol ethyl ether) was added, water and by-product alcohol which had been subjected to hydrolytic condensation were distilled off to obtain 440 g of a solution (compound concentration: 10%) of polysiloxane compound 1 in PGEE. The polystyrene-equivalent molecular weight in terms of polystyrene of polysiloxane compound 1 was measured and found to be Mw = 2,900.

### [Synthesis Examples 2 to 8]

Synthesis Example 2 to Synthesis Example 8 were carried out using the monomers shown in Table 1 under the same conditions as in Synthesis Example 1 to obtain the target products (polysiloxane compounds 2 to 8).

**[Table 1]**

| Synthesis Example | Raw Material for Reaction | Mw |
|---|---|---|
| 1 | Compound (101): 30.6 g, Compound (102): 38.1 g, Compound (110): 5.9 g | 2900 |
| 2 | Compound (101): 30.6 g, Compound (102): 38.1 g, Compound (111): 6.4 g | 2300 |
| 3 | Compound (101): 30.6 g, Compound (102): 38.1 g, Compound (112): 7.0 g | 2900 |
| 4 | Compound (101): 30.6 g, Compound (102): 38.1 g, Compound (113): 6.8 g | 2300 |
| 5 | Compound (101): 30.6 g, Compound (102): 38.1 g, Compound (114): 7.1 g | 2500 |
| 6 | Compound (101): 30.6 g, Compound (102): 38.1 g, Compound (115): 8.9 g | 2600 |
| 7 | Compound (101): 30.6 g, Compound (102): 38.1 g, Compound (116): 8.0 g | 2300 |
| 8 | Compound (100): 5.0 g, Compound (101): 30.6 g, Compound (102): 38.1 g | 2500 |

The compounds used in the Synthesis Examples are shown below.
PhSi(OCH₃)₃: Compound (100)
CH₃Si(OCH₃)₃: Compound (101)
Si(OCH₃)₄: Compound (102)

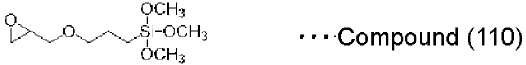

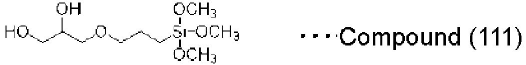

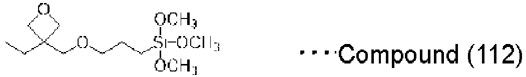

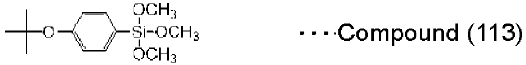

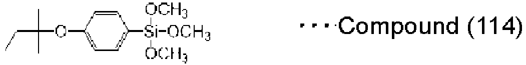

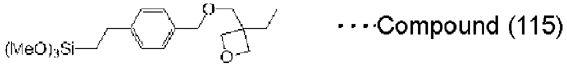

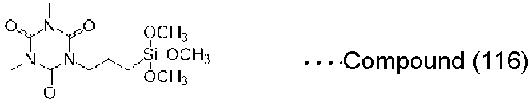

### [Synthesis example 9]

1400 g of ethanol, 700 g of ultrapure water, and 50 g of 25% tetramethylammonium hydroxide were mixed to form a homogeneous solution at 40°C under a nitrogen atmosphere. A mixture of 138.6 g of 2-(3,4-epoxycyclohexyl)ethyltrimethoxysilane and 37.2 g of phenyltrimethoxysilane was slowly added dropwise to the homogeneous solution, and the reaction was carried out at 40°C for 2 hours. After the reaction was completed, 35 g of acetic acid was added to the solution to stop the reaction, and the ethanol was distilled off under reduced pressure. 2000 ml of ethyl acetate was added to the solution subjected to the distillation and the aqueous layer was separated. The organic layer was washed twice with 400 ml of ultrapure water, after which 1000 g of PGMEA (propylene glycol monomethyl ether acetate) was added and the water and low-boiling-point solvent were distilled off to recover 600 g of a solution of polysiloxane compound 9 (compound concentration 20%) in PGMEA. The molecular weight in terms of polystyrene of polysiloxane compound 9 was measured and found to be Mw = 2800.

### [Preparation of Composition for Forming Silicon-containing Hard Mask Film]

Polysiloxane Compounds 1 to 9 obtained in the above Synthesis Examples, crosslinking catalysts (XLC-1 to 3), acid generators (AG1 to 4), a crosslinking agent (XL1), an organic solvent, and water were mixed in the ratios shown in Table 2, and each mixture was filtered through a 0.1 µm fluororesin filter to prepare solutions of compositions for forming a silicon-containing underlayer film, which were named UDL-1 to 18, respectively.

**[Table 2]**

| Composition for Forming Silicon-containing Hard Mask Film | Silicon-containing Polymer | Crosslinking Catalyst | Additive | Organic Solvent | Water |
|---|---|---|---|---|---|
| | (Parts by mass) | (Parts by mass) | (Parts by mass) | (Parts by mass) | (Parts by mass) |
| UDL-1 | Compound 1 (1) | None | | PGEE (100) | Water (10) |
| UDL-2 | Compound 2 (1) | None | | PGEE (100) | Water (10) |
| UDL-3 | Compound 3 (1) | None | | PGEE (100) | Water (10) |
| UDL-4 | Compound 4 (1) | None | | PGEE (100) | Water (10) |
| UDL-5 | Compound 5 (1) | None | | PGEE (100) | Water (10) |
| UDL-6 | Compound 6 (1) | None | | PGEE (100) | Water (10) |
| UDL-7 | Compound 7 (1) | None | | PGEE (100) | Water (10) |
| UDL-8 | Compound 8 (1) | None | | PGEE (100) | Water (10) |
| UDL-9 | Compound 9 (1) | None | | PGMEA (100) | - |
| UDL-10 | Compound 1 (1) | XLC-1 (0.03) | | PGEE (100) | Water (10) |
| UDL-11 | Compound 2 (1) | XLC-2 (0.03) | | PGEE (100) | Water (10) |
| UDL-12 | Compound 3 (1) | XLC-3 (0.03) | | PGEE (100) | Water (10) |
| UDL-13 | Compound 4 (1) | XLC-1 (0.03) | AG1 (0.01) | PGEE (100) | Water (10) |
| UDL-14 | Compound 5 (1) | XLC-2 (0.03) | AG2 (0.01) | PGEE (100) | Water (10) |
| UDL-15 | Compound 6 (1) | XLC-3 (0.03) | AG3 (0.01) | PGEE (100) | Water (10) |
| UDL-16 | Compound 7 (1) | XLC-1 (0.03) | AG4 (0.01) | PGEE (100) | Water (10) |
| UDL-17 | Compound 8 (1) | XLC-2 (0.03) | AG1 (0.01) | PGEE (100) | Water (10) |
| UDL-18 | Compound 9 (1) | - | XL1 (0.3) | PGMEA (100) | - |

The crosslinking catalysts used are as follows.
XLC-1: Triphenylsulfonium nitrate
XLC-2: Mono(triphenylsulfonium) maleate
XLC-3: Triethylphenylammonium iodide

The organic solvents used are as follows.
PGEE: Propylene glycol ethyl ether
PGMEA: Propylene glycol methyl ether acetate

The acid generators used are as shown in Table 3 below.

**[Table 3]**

| Acid Generator | Structure |
|---|---|
| 1 | 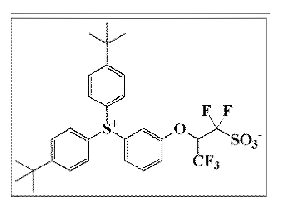 (AG1) |
| 2 | 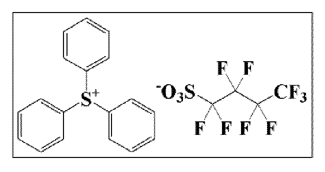 (AG2) |
| 3 | 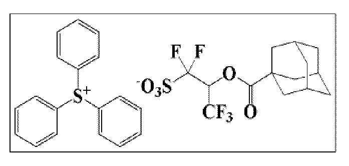 (AG3) |
| 4 | (CH₃CH₂)₃N⁺H C₄F₉SO₃⁻ |
| | (AG4) |

The crosslinking agent (XL1) used is as follows.

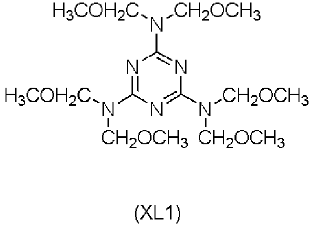

### [Solvent resistance evaluation]

On a substrate, a 40-pair in which each pair had 4 nm of Si film and 3 nm of Mo film was formed, and then a 3 nm Si film was formed on the surface to obtain multilayer reflective film . On this multilayer reflective film, a 2.5 nm Ru layer was formed as a protective layer, and then a 70 nm TaN absorber layer were formed. On this absorber layer, any one of the compositions for forming a silicon-containing hard mask film (UDL-1 to 18) prepared as the above was applied, and the resulting coating film was baked under the baking conditions shown in Table 4 to obtain a silicon-containing hard mask film. Thus, the composites for Examples 1-1 to 1-20 were obtained.

The film thicknesses of the substrate of the obtained composites of Examples 1-1 to 1-20 from the center part to the outer periphery part were measured, and the average film thickness (a [nm]) was calculated. Next, a PGMEA solvent was dispensed onto it, and then it was left for 30 seconds, spin-dried, and baked at 110°C for 600 seconds to evaporate the PGMEA, and then the film thickness (b [nm]) was measured.

Table 4 below shows the film thicknesses a and b, and the value of (b/a) x 100 as an index of solvent resistance.

**[Table 4]**

| Example 1 | Composition for Forming Silicon-containing Hard Mask Film | Baking Conditions | | Film Thickness a (nm) | Film Thickness b (nm) | Solvent resistance |
|---|---|---|---|---|---|---|
| | | Temperature | Time | | | (b/a x 100) (%) |
| Example 1-1 | UDL-1 | 150°C | 600 s | 200.8 | 197.6 | 98.4% |
| Example 1-2 | UDL-2 | 150°C | 600 s | 202.1 | 198.4 | 98.2% |
| Example 1-3 | UDL-3 | 150°C | 600 s | 199.8 | 196.9 | 98.5% |
| Example 1-4 | UDL-4 | 150°C | 600 s | 201.3 | 198.4 | 98.6% |
| Example 1-5 | UDL-5 | 150°C | 600 s | 200.4 | 196.9 | 98.3% |
| Example 1-6 | UDL-6 | 150°C | 600 s | 202.1 | 199.3 | 98.6% |
| Example 1-7 | UDL-7 | 150°C | 600 s | 200.9 | 198.1 | 98.6% |
| Example 1-8 | UDL-8 | 150°C | 600 s | 201.1 | 197.6 | 98.3% |
| Example 1-9 | UDL-9 | 150°C | 600 s | 198.8 | 195.6 | 98.4% |
| Example 1-10 | UDL-10 | 120°C | 600 s | 201.7 | 201 | 99.7% |
| Example 1-11 | UDL-11 | 120°C | 600 s | 203.4 | 202.7 | 99.7% |
| Example 1-12 | UDL-12 | 120°C | 600 s | 200.8 | 200.1 | 99.7% |
| Example 1-13 | UDL-13 | 120°C | 600 s | 203.7 | 203 | 99.7% |
| Example 1-14 | UDL-14 | 120°C | 600 s | 202.2 | 201.6 | 99.7% |
| Example 1-15 | UDL-15 | 120°C | 600 s | 203.5 | 202.8 | 99.7% |
| Example 1-16 | UDL-16 | 120°C | 600 s | 202.5 | 201.7 | 99.6% |
| Example 1-17 | UDL-17 | 120°C | 600 s | 202.3 | 201.5 | 99.6% |
| Example 1-18 | UDL-18 | 120°C | 600 s | 199.5 | 196.1 | 98.3% |
| Example 1-19 | UDL-18 | 140°C | 600 s | 199.8 | 198.1 | 99.1% |
| Example 1-20 | UDL-18 | 140°C | 1200 s | 199.7 | 199.4 | 99.8% |

As shown in Table 4, in Examples 1-1 to 1-20, the remaining film rate ((b/a) x 100) after PGMEA rinsing treatment was 98% or more, and it can be seen that the crosslinking reaction had occurred even on the mask blank and sufficient solvent resistance was exhibited. In particular, it was found that Examples UDL-10 to 17 containing a crosslinking catalyst showed excellent curing properties and can be processed at lower baking temperatures. In addition, in Examples 1-18 to 1-20, it was confirmed that the higher the baking temperature and the longer the baking time, the more the solvent resistance was improved.

In addition, in Examples 1-1 to 1-20, it was confirmed that all of the above prepared compositions for forming a silicon-containing hard mask film (UDL-1 to 18) cured at a temperature of 50°C or more and 180°C or less, and more specifically, at a temperature of 120°C or more and 150°C or less.

### [Reflectivity]

### (Reference substrate with multilayer reflective film)

On a substrate, a 40-pair in which each pair had 4 nm of Si film and 3 nm of Mo film was formed, and then a 3 nm Si film was formed on the surface to obtain a multilayer reflective film. On this multilayer reflective film, a 2.5 nm Ru layer was formed as a protective film. Thus, a reference substrate with a multilayer reflective film was obtained.

The peak reflectivity of EUV light (wavelength 13.5 nm; the same below) at an incidence angle of 6° on the main surface of this reference substrate with a multilayer reflective film was measured, and was found to be 65%.

### (Example 2-1)

Next, a multilayer reflective film layer and a protective film were formed on the main surface of the above-mentioned mask blank substrate under the same conditions as those for producing the above-mentioned reference substrate with a multilayer reflective film layer, to produce the substrate with a multilayer reflective film layer of Example 2-1. This substrate with a multilayer reflective film layer was subjected to baking treatment under the conditions of 120°C for 600 seconds, for which the solvent resistance of the silicon-containing hard mask film in the above Example was 98% or higher. Thus, the evaluation substrate of Example 2-1 was obtained. The peak reflectivity of EUV light (wavelength 13.5 nm; the same below) at an incidence angle of 6° on the major surface of this evaluation board was measured, and was found to be 65%.

### (Example 2-2)

An evaluation substrate for Example 2-2 was produced under the same conditions as Example 2-1, except that the baking conditions for the substrate with a multilayer reflective film layer for Example 2-1 were changed to 150°C for 600 seconds. The peak reflectivity of EUV light (wavelength 13.5 nm; the same below) at an incidence angle of 6° on the major surface of this evaluation board was measured, and was found to be 65%.

### (Example 2-3)

An evaluation substrate for Example 2-3 was produced under the same conditions as Example 2-1, except that the baking conditions for the substrate with a multilayer reflective film layer for Example 2-1 were changed to 180°C for 600 seconds. The peak reflectivity of EUV light (wavelength 13.5 nm; the same below) at an incidence angle of 6° on the major surface of this evaluation board was measured, and was found to be 64%.

### (Comparative Example 2-1)

A substrate for the mask blank was prepared under the same conditions as in Example 2-1, except that the baking conditions for the substrate with multilayer reflective film were changed to 200°C for 600 seconds. The peak reflectivity of EUV light (wavelength 13.5 nm; the same below) at an incidence angle of 6° on the major surface of this substrate with a multilayer reflective film was measured, and it was 62%. Furthermore, when a cross-section of the resulting multilayer reflective film was observed with a transmission electron microscope (TEM), an interdiffusion layer in which Si and Mo were mixed was observed.

From the above results, it was found that, because the photomask blank of the present invention includes a silicon-containing hard mask film that is a cured product of a composition for forming a silicon-containing hard mask, the composition being to cure at a temperature of 50°C or more and 180°C or less, there is no need to bake at a temperature exceeding 180°C when forming the silicon-containing hard mask film, so a silicon-containing hard mask film that is useful as a hard mask can be formed at a temperature of 50°C or more and 180°C or less without deteriorating the EUV-light reflectivity of the multilayer reflective film layer, as demonstrated in Examples 2-1 to 2-3. On the other hand, it was found that, unlike the present invention, if using a composition for forming a silicon-containing hard mask that needs the baking temperature of the silicon-containing hard mask film to exceed 180°C, interlayer mixing of the multilayer reflective film layer occurs, resulting in a deterioration in the EUV-light reflectivity.

### [Exposure evaluation]

### (Examples 3-1 to 3-24)

On a substrate, a 40-pair in which each pair had 4 nm of Si film and 3 nm of Mo film was formed, and then a 3 nm Si film was formed on the surface to obtain multilayer reflective film. On this multilayer reflective film, a 2.5 nm Ru layer was formed as a protective film, and then a 70 nm TaN absorber layer was formed. On this absorber layer, a CrN film was formed to a thickness of 6 nm as the first layer of the hard mask film.

Any one of the compositions for forming a silicon-containing hard mask film (UDL-1 to 18) prepared above was applied onto the CrN film by a spin coating method, and then baked under the baking conditions shown in Table 5 to form a silicon-containing hard mask layer (silicon oxide material film) with a thickness of 20 nm as the second layer of the hard mask.

Next, on the substrate on which the above-mentioned silicon-containing hard mask layer had been formed, a chemically amplified resist solution for electron beams, SEBP-504G manufactured by Shin-Etsu Chemical Co., Ltd., was formed as a photoresist film to a film thickness of 90 nm or a film thickness of 60 nm using a spin coater. Thus, a photomask blank of each Example was produced.

Next, the photoresist film of each photomask blank was exposed using an electron beam exposure apparatus (EBM5000 manufactured by NuFLARE, accelerating voltage 50 keV), subjected to baking at 110°C for 10 minutes (PEB: post-exposure bake), and developed with a 2.38 % by mass aqueous solution of tetramethylammonium hydroxide, and thereby a positive photoresist pattern consisting of a 100 nm-line pattern was obtained. Exposure was performed wherein the exposure amount resolving the top and bottom of an obtained 100 nm-line- and-space at 1 : 1 was taken as the optimal exposure amount (sensitivity: Eop).

The line edge roughness of the resist pattern was measured. The line edge roughness was measured using an SEM (E3640 manufactured by Advantest Corporation) by detecting 80 points on each of the edges of 32 lines of 100 nm LS, the variation (standard deviation, σ) was calculated and multiplied by three, and the tripled value (3σ) was defined as the LER (nm).

Next, while using the photoresist pattern as an etching mask, the mask blank was processed according to the following procedure.

First, using the photoresist pattern as a mask, the part of the silicon-containing hard mask film exposed from the resist pattern was dry-etched using a dry etching apparatus under the following fluorine-based dry-etching condition, to conduct patterning.

### [Etching condition for silicon-containing film]

RF1 (RIE): CW 54 V
RF2 (ICP): CW 325 W
Pressure: 5 mTorr
SF₆: 18 sccm
O₂: 45 sccm
Etching time: 1 min

Next, after the photoresist pattern was stripped off with oxygen plasma, the Cr hard mask film was then dry-etched under the following oxygen-containing chlorine-based dry-etching condition while using the patterned silicon-containing hard mask film (silicon-containing film pattern) as a mask, to conduct patterning.

### [Etching condition for Cr hard mask film]

RF1 (RIE): CW 10 W
RF2 (ICP): CW 300 W
Pressure: 5 mTorr
Cl₂: 150 sccm
O₂: 50 sccm
He: 10 sccm
Etching time: 1 min

Next, the exposed TaN absorber layer film was dry etched and patterned under etching conditions-1 and successive etching conditions-2 while using the patterned Cr hard mask film as a mask.

### [TaN film etching condition-1]

RF1 (RIE): CW 54 W
RF2 (ICP): CW 325 W
Pressure: 5 mTorr
SF₆: 18 sccm
He: 130 sccm
Etching time: 10 sec

### [TaN film etching condition-2]

RF1 (RIE): CW 7.6 W
RF2 (ICP): CW 300 W
Pressure: 5 mTorr
Cl₂: 150 sccm
He: 10 sccm
Etching time: 5 min

### (Comparative Examples 3-1 and 3-2)

Photomask blanks were fabricated in the same manner as in Example 3-1 or 3-14, except that a photoresist film was directly formed on the CrN film with a thickness shown in Table 5 without forming a silicon-containing hard mask layer. Then, the photomask blanks were processed in the same manner as in Example 3-1 or 3-14.

The patterned line edge roughness formed by the above etching in Examples 3-1 to 3-24 and Comparative Examples 3-1 and 3-2 was measured. The line edge roughness was measured using an SEM (E3640 manufactured by Advantest Corporation) by detecting 80 points on each of the edges in 32 lines of 100 nm LS, the variation (standard deviation, σ) was calculated and multiplied by three, and the tripled value (3σ) was defined as the LER (nm). The results indicate that the smaller the value is, the better the performance is. In addition, the cross-sectional shape (pattern shape) was observed using an electron microscope (S-4800) manufactured by Hitachi High-Technologies Corporation. If no tapered shapes or undercut shapes were observed, the shape was rated as good. When clearly tapered shapes or undercut shapes were observed, the shape was rated as poor. The results are shown in Table 5.

**[Table 5]**

| Example 3 and Comparative Example 3 | Composition for Forming silicon-containing Hard Mask Film | Baking Condition | | Resist Film Thickness | Resist Pattern | Post-etching pattern | |
|---|---|---|---|---|---|---|---|
| | | Temperature | Time | (nm) | LER (nm) | Cross-Sectional Shape | LER (nm) |
| Example 3-1 | UDL-1 | 150°C | 600 s | 90 | 2.1 | Rectangle | 1.9 |
| Example 3-2 | UDL-1 | 180°C | 600 s | 90 | 2.2 | Rectangle | 1.9 |
| Example 3-3 | UDL-2 | 150°C | 600 s | 90 | 2.2 | Rectangle | 1.9 |
| Example 3-4 | UDL-3 | 150°C | 600 s | 90 | 2.2 | Rectangle | 1.9 |
| Example 3-5 | UDL-4 | 150°C | 600 s | 90 | 2.2 | Rectangle | 1.9 |
| Example 3-6 | UDL-5 | 150°C | 600 s | 90 | 2.2 | Rectangle | 1.9 |
| Example 3-7 | UDL-6 | 150°C | 600 s | 90 | 2.2 | Rectangle | 1.9 |
| Example 3-8 | UDL-7 | 150°C | 600 s | 90 | 2.3 | Rectangle | 1.9 |
| Example 3-9 | UDL-8 | 150°C | 600 s | 90 | 2.5 | Rectangle | 2.2 |
| Example 3-10 | UDL-9 | 150°C | 600 s | 90 | 2.4 | Rectangle | 2.0 |
| Example 3-11 | UDL-10 | 120°C | 600 s | 90 | 2.0 | Rectangle | 1.7 |
| Example 3-12 | UDL-10 | 150°C | 600 s | 90 | 2.0 | Rectangle | 1.7 |
| Example 3-13 | UDL-10 | 180°C | 600 s | 90 | 2.1 | Rectangle | 1.7 |
| Example 3-14 | UDL-10 | 120°C | 600 s | 60 | 2.1 | Rectangle | 1.8 |
| Example 3-15 | UDL-11 | 120°C | 600 s | 90 | 2.1 | Rectangle | 1.8 |
| Example 3-16 | UDL-12 | 120°C | 600 s | 90 | 1.9 | Rectangle | 1.7 |
| Example 3-17 | UDL-13 | 120°C | 600 s | 90 | 2.1 | Rectangle | 1.8 |
| Example 3-18 | UDL-13 | 180°C | 600 s | 90 | 2.1 | Rectangle | 1.8 |
| Example 3-19 | UDL-13 | 120°C | 600 s | 60 | 2.2 | Rectangle | 1.8 |
| Example 3-20 | UDL-14 | 120°C | 600 s | 90 | 2.1 | Rectangle | 1.8 |
| Example 3-21 | UDL-15 | 120°C | 600 s | 90 | 2.1 | Rectangle | 1.8 |
| Example 3-22 | UDL-16 | 120°C | 600 s | 90 | 2.2 | Rectangle | 1.8 |
| Example 3-23 | UDL-17 | 120°C | 600 s | 90 | 2.4 | Rectangle | 2.1 |
| Example 3-24 | UDL-18 | 140°C | 1200 s | 90 | 2.3 | Rectangle | 2.1 |
| Comparative Example 3-1 | None | - | - | 90 | 2.7 | Taper | 2.8 |
| Comparative Example 3-2 | None | - | - | 60 | 3.5 | Taper | 3.9 |

As shown in Table 5, it was confirmed that the photomask blanks of Examples 3-1 to 3-24 of the present invention, which includes the silicon-containing hard mask film, had better edge roughness of the resist pattern and also had excellent pattern shapes after etching, compared to Comparative Examples 3-1 and 3-2, which did not have the silicon-containing hard mask film. Examples 3-1 to 3-8, which used polysiloxanes (compounds 1 to 7) containing an organic group having one or more carbon-oxygen single bonds or carbon-oxygen double bonds, had good edge roughness of the resist pattern. This is speculated to be due to good adhesion to the resist pattern. Furthermore, for Examples 3-11 to 3-23, which had compositions for forming a silicon-containing hard mask film (UDL-10 to 17) containing a crosslinking catalyst, the edge roughness of the resist pattern was further better than that of compositions not having a crosslinking catalyst, and the edge roughness after etching was also better. This is speculated to be because the addition of a cross-linking catalyst improved the dense of the silicon-containing hard mask film.

As shown in Comparative Example 3-2, if the resist film thickness was made 60 nm, deterioration of the LER was confirmed due to deterioration of the cross-sectional shape. On the other hand, in Examples 3-14 and 3-19, which had a silicon-containing hard mask film, no degeneration of the cross-sectional shape was observed, and good LER was obtained. This is speculated to be due to good adhesion between the silicon-containing hard mask film and the resist film.

As described above, since the photomask blank of the present invention contains a silicon-containing hard mask film that is useful as a hard mask film, fine resist patterns can be transferred to the absorber layer with high accuracy. In addition, the composition for forming a silicon-containing hard mask film used in the present invention can be cured at a temperature range of 50°C or more to 180°C or less, which makes it possible to improve the transfer accuracy of the resist pattern without inducing interlayer mixing in the multilayer reflective film. That is, the present invention can provide a photomask blank that can provide a photomask on which a fine pattern has been formed with high accuracy without degrading the EUV-light reflectivity.

The present description includes the following embodiments.
[1] A photomask blank comprising:
   a substrate;
   a multilayer reflective film layer that is formed on the substrate and reflects an EUV light;
   an absorber layer that is formed on the multilayer reflective film layer and absorbs the EUV light;
   a silicon-containing hard mask film that is formed directly or indirectly on the absorber layer; and
   a photoresist film formed on the silicon-containing hard mask film;
   wherein the silicon-containing hard mask film is a cured material of a composition for forming a silicon-containing hard mask film, the composition for forming a silicon-containing hard mask film is to cure at a temperature of 50°C or more and 180°C or less.
[2] The photomask blank according to [1], wherein the composition for forming a silicon-containing hard mask film contains a silicon-containing compound having one or more of a repeating unit represented by the following general formula (Sx-1), a repeating unit represented by the following general formula (Sx-2), and a partial structure represented by the following general formula (Sx-3), 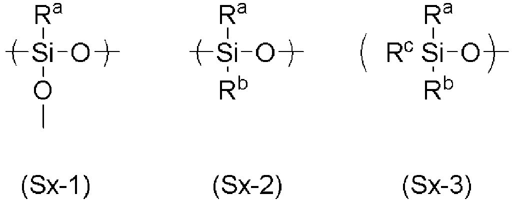 wherein R^{a}, R^{b}, and R^{c} are monovalent organic groups having 1 to 30 carbon atoms, and may be the same as or different from each other.
[3] The photomask blank according to [2], wherein at least one of R^{a} to R^{c} in the formulas (Sx-1) to (Sx-3) is an organic group having one or more of a carbon-oxygen single bond and a carbon-oxygen double bond.
[4] The photomask blank according to any one of [1] to [3], wherein the composition for forming a silicon-containing hard mask film further contains a crosslinking catalyst.
[5] The photomask blank according to [4], wherein the crosslinking catalyst is a sulfonium salt, an iodonium salt, a phosphonium salt, an ammonium salt, an alkali metal salt, or a polysiloxane having any one of a sulfonium salt, an iodonium salt, a phosphonium salt, and an ammonium salt as a part of its structure.
[6] A method for processing a photomask blank, comprising:
   (i-1) a step of forming a photoresist pattern on the photoresist film wherein the photomask blank according to any one of [1] to [5] is irradiated with an electron beam, and then a development is performed with a developer;
   (i-2) a step of forming a silicon-containing film pattern on the silicon-containing hard mask film by etching the silicon-containing hard mask while using the photoresist pattern as a mask; and
   (i-3) a step of directly or indirectly processing the absorber layer by performing etching while using the silicon-containing film pattern as a mask.
[7] A method for manufacturing a photomask blank, comprising:
   a step of providing a substrate;
   a step of forming a multilayer reflective film layer that reflects an EUV light on the substrate;
   a step of forming an absorber layer that absorbs the EUV light on the multilayer reflective film layer;
   a step of applying a composition for forming a silicon-containing hard mask film directly or indirectly onto the absorber layer, the composition for forming a silicon-containing hard mask film being to cure at a temperature of 50°C or higher and 180°C or lower, to obtain a coating film, and curing the coating film at a temperature of 50°C or higher and 180°C or lower so as to form a silicone-containing hard mask film; and
   a step of forming a photoresist film on the silicon-containing hard mask film.

It should be noted that the present invention is not limited to the above embodiments. The embodiments described above are just examples, and any examples that have substantially the same features and demonstrate the same functions and effects as those in the technical concepts disclosed in the claims of the present invention are included in the technical scope of the present invention.

## Claims

1. A photomask blank comprising:
a substrate;
a multilayer reflective film layer that is formed on the substrate and reflects an EUV light;
an absorber layer that is formed on the multilayer reflective film layer and absorbs the EUV light;
a silicon-containing hard mask film that is formed directly or indirectly on the absorber layer; and
a photoresist film formed on the silicon-containing hard mask film;
wherein the silicon-containing hard mask film is a cured material of a composition for forming a silicon-containing hard mask film, the composition for forming a silicon-containing hard mask film is to cure at a temperature of 50°C or more and 180°C or less.

2. The photomask blank according to claim 1, wherein the composition for forming a silicon-containing hard mask film contains a silicon-containing compound having one or more of a repeating unit represented by the following general formula (Sx-1), a repeating unit represented by the following general formula (Sx-2), and a partial structure represented by the following general formula (Sx-3), 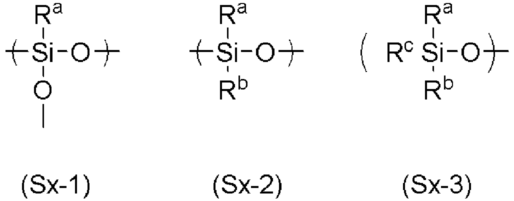 wherein R^{a}, R^{b}, and R^{c} are monovalent organic groups having 1 to 30 carbon atoms, and may be the same as or different from each other.

3. The photomask blank according to claim 2, wherein at least one of R^{a} to R^{c} in the formulas (Sx-1) to (Sx-3) is an organic group having one or more of a carbon-oxygen single bond and a carbon-oxygen double bond.

4. The photomask blank according to any one of claims 1 to 3, wherein the composition for forming a silicon-containing hard mask film further contains a crosslinking catalyst.

5. The photomask blank according to claim 4, wherein the crosslinking catalyst is a sulfonium salt, an iodonium salt, a phosphonium salt, an ammonium salt, an alkali metal salt, or a polysiloxane having any one of a sulfonium salt, an iodonium salt, a phosphonium salt, and an ammonium salt as a part of its structure.

6. A method for processing a photomask blank, comprising:
(i-1) a step of forming a photoresist pattern on the photoresist film wherein the photomask blank according to any one of claims 1 to 5 is irradiated with an electron beam, and then a development is performed with a developer;
(i-2) a step of forming a silicon-containing film pattern on the silicon-containing hard mask film by etching the silicon-containing hard mask while using the photoresist pattern as a mask; and
(i-3) a step of directly or indirectly processing the absorber layer by performing etching while using the silicon-containing film pattern as a mask.

7. A method for manufacturing a photomask blank, comprising:
a step of providing a substrate;
a step of forming a multilayer reflective film layer that reflects an EUV light on the substrate;
a step of forming an absorber layer that absorbs the EUV light on the multilayer reflective film layer;
a step of applying a composition for forming a silicon-containing hard mask film directly or indirectly onto the absorber layer, the composition for forming a silicon-containing hard mask film being to cure at a temperature of 50°C or higher and 180°C or lower, to obtain a coating film, and curing the coating film at a temperature of 50°C or higher and 180°C or lower so as to form a silicone-containing hard mask film; and
a step of forming a photoresist film on the silicon-containing hard mask film.
